# EUROPEAN PATENT APPLICATION

(11) **EP 4 800 746 A1**
(43) Date of publication of application: **02.09.2026**
(21) Application number: 24866547.3
(22) Date of filing: 25.10.2024
(51) Int. Cl.: H01L 23/36, C08L 21/00, C08L 83/04, C09J 7/20, C09J 7/38, C09J 133/00

(54) **THERMALLY CONDUCTIVE SHEET**

(30) Priority: 27.10.2023 JP 2023184843
(71) Applicant: Sekisui Chemical Co., Ltd., Osaka-shi, Osaka 530-8565 (JP)
(72) Inventor: URAYAMA, Takahiro, Mishima-gun, Osaka 618-0021 (JP); ASHIBA, Kouji, Saitama-city, Saitama 338-0837 (JP)
(74) Representative: Ter Meer Steinmeister & Partner
(86) International application number: PCT/JP2024/038235
(87) International publication number: WO 2025/089425

(57) **Abstract**

A heat conductive sheet including a heat conductive layer including a polymer matrix and a heat conductive filler, at least one surface of the heat conductive sheet having pressure-sensitive adhesive properties, wherein, in the heat conductive sheet, an amount of volatile components measured by thermal desorption GC-MS at 150°C is 2 ppm by mass or more and 80 ppm by mass or less.

## Description

### Technical Field

The present invention relates to a heat conductive sheet.

### Background Art

In conjunction with the recent increasing wiring density of multilayer wiring boards, increasing wiring density in semiconductor packages, increasing installing density of electronic components, and increasing heat generation per unit area due to the increased integration of semiconductor devices and the like, enhanced heat dissipation is desired for semiconductor packages. Semiconductor packages are known to have a heat dissipating material that is disposed between a heating element, such as a semiconductor chip, and a heat-dissipating element, which is also referred to as a heat spreader, and tightly adhered thereto, to dissipate heat. Conventionally, heat conductive grease is widely used as a heat dissipating material placed between a semiconductor chip and a heat spreader for use.

Semiconductor packages are generally heated to a certain temperature or higher during use. Since members such as a substrate, a semiconductor chip, and a heat spreader each have a different coefficient of thermal expansion, they may warp when heated. Recently, the gap between the semiconductor chip and the heat spreader has been widened due to the warpage of the semiconductor chip in conjunction with an increase in size of a chip. The heat conductive grease is unable to adjust to such warpage, resulting in defects where a gap is formed. Thus, the use of a heat conductive sheet instead of the heat conductive grease has been studied.

The heat conductive sheet to be used in the above-described application is required to have enhanced adjustability to warpage while enhancing heat dissipation. The reason is that it is concerned that the heat conductive sheet might peel from the semiconductor chip or heat spreader due to a failure to adjust to the warpage as with the heat conductive grease when there is a lack of adjustability to peripheral members.

On the other hand, a conventional heat conductive sheet sometimes includes a pressure-sensitive adhesive layer formed on the surface of the sheet for the purpose of enhancing tackiness or the like. For example, PTL 1 discloses a heat conductive sheet on which an acrylic-based pressure-sensitive adhesive liquid is sprayed and dried for 1 minute at a normal temperature in the air to form a pressure-sensitive adhesive layer on one surface thereof.

Moreover, in a semiconductor testing process of checking for the performance of a semiconductor package, a testing technique with enhanced heat dissipation for the semiconductor package is expected in conjunction with the increasing heat generation of the semiconductor package. The semiconductor testing process involves pressing a test heat against the semiconductor package via a heat dissipating material to check the temperature of the semiconductor chip. Since the heat dissipating material needs to be repeatedly usable, using a heat conductive sheet instead of heat conductive grease is being considered. However, high adhesion to the test head is required.

### Citation List

### Patent Literature

PTL1: JP 2020-116874 A

### Summary of Invention

### Technical Problem

In general, semiconductor packages are manufactured through a reflow process, which generally involves heating at high temperatures. Therefore, a heat conductive sheet placed between a semiconductor chip and a heat spreader for use is sometimes required to maintain adhesion to an adherend such as the semiconductor chip and the heater spreader even after being heated to high temperature.

Although a heat conductive sheet including a pressure-sensitive adhesive layer formed under conditions as described in PTL 1 is thought to have enhanced initial adhesion to an adherend, the use of the heat conductive sheet in an application where it is heated to a high temperature, for example, in a flow process, causes a problem such as deteriorated adhesion between the heat conductive sheet and an adherend interface during heating at high temperatures.

A semiconductor testing process also requires the conventional heat conductive sheet to have strong adhesion to a test head. However, a conventional heat conductive sheet often exhibits insufficient adhesion when heated to a high temperature, thus making it difficult to carry the sheet on the test head occasionally.

Accordingly, an object of the present invention is to provide a heat conductive sheet capable of maintaining strong adhesion before and after heating at high temperatures, such as a reflow process.

### Solution to Problem

The present inventors have investigated the cause of deteriorated adhesion of the heat conductive sheet and discovered that a trace amount of volatile components remaining in the pressure-sensitive adhesive layer and heat conductive sheet volatilize and generate cells in heating processes such as a reflow process and a mounting process before the reflow process, thereby deteriorating the adhesion between the heat conductive sheet and the adherend interface. They also discovered that adhesion of the heat conductive sheet to the adherend can be enhanced when volatile components are contained in a certain amount or more. Based on these findings, the present inventors have found that the above object can be achieved by adjusting amounts of volatile components when the heat conductive sheet is heated at 150°C so that the amounts fall within a specified range while imparting pressure-sensitive adhesive properties to at least one surface of the heat conductive layer that makes up the heat conductive sheet.

Specifically, the present invention provides [1] to [10] below.
[1] A heat conductive sheet comprising a heat conductive layer comprising a polymer matrix and a heat conductive filler, at least one surface of the heat conductive sheet having pressure-sensitive adhesive properties, in the heat conductive sheet, an amount of volatile components measured by thermal desorption GC-MS at 150°C being 2 ppm by mass or more and 80 ppm by mass or less.
[2] The heat conductive sheet according to [1], wherein the polymer matrix is organopolysiloxane.
[3] The heat conductive sheet according to [1] or [2], comprising a pressure-sensitive adhesive layer on at least one surface of the heat conductive layer.
[4] The heat conductive sheet according to [3], wherein the pressure-sensitive adhesive layer is formed by spray coating.
[5] The heat conductive sheet according to [3] or [4], wherein the pressure-sensitive adhesive layer is an acrylic pressure-sensitive adhesive layer.
[6] The heat conductive sheet according to [5], wherein the acrylic pressure-sensitive adhesive layer comprises a reactive double bond.
[7] The heat conductive sheet according to any one of [1] to [6], wherein the pressure-sensitive adhesive properties are lost due to heating at 260°C for 3 minutes.
[8] The heat conductive sheet according to any one of [1] to [7], wherein, in the heat conductive sheet, an amount of volatile components measured by thermal desorption GC-MS at 260°C is 2500 ppm by mass or less.
[9] The heat conductive sheet according to any one of [1] to [8], wherein a pressure-sensitive adhesive force of the at least one surface measured with a tack test is 2 N or more.
[10] A heat conductive sheet comprising a heat conductive layer comprising a polymer matrix and a heat conductive filler, at least one surface of the heat conductive layer having pressure-sensitive adhesive properties, in the heat conductive sheet, an amount of volatile components measured by thermal desorption GC-MS at 150°C being 2 ppm by mass or more and 80 ppm by mass or less.

### Advantageous Effect of Invention

According to the present invention, it is possible to provide a heat conductive sheet capable of maintaining strong adhesion before and after heating at high temperatures, for example, in a reflow process.

### Brief Description of Drawing

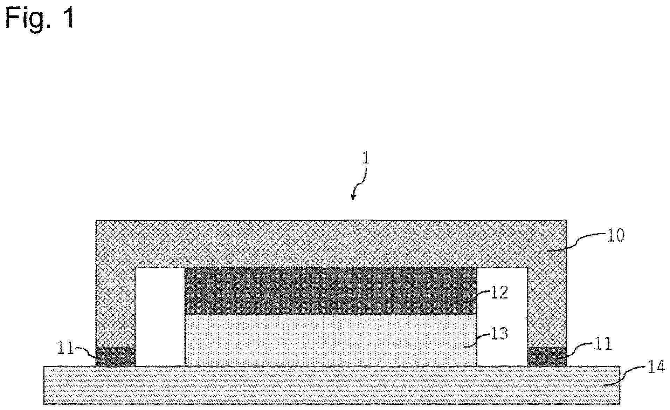

[Fig. 1] Fig. 1 is a schematic view illustrating an example of a method for mounting a heat conductive sheet.

### Description of Embodiments

### [Heat Conductive Sheet]

A heat conductive sheet of the present invention includes a heat conductive layer including a polymer matrix and a heat conductive filler, and at least one surface of the heat conductive sheet has pressure-sensitive adhesive properties. Hereinafter, the heat conductive sheet is described in detail.

### (Amount of Volatile Components)

In the heat conductive sheet of the present invention, an amount of volatile components measured by thermal desorption GC-MS at 150°C (hereinafter, also referred to simply as an "amount of volatile components at 150°C") is 2 ppm by mass or more and 80 ppm by mass or less. When the amount of volatile components at 150°C is less than 2 ppm by mass, the amount of volatile components contained in a pressure-sensitive adhesive in the heat conductive sheet or in the heat conductive sheet itself is too small, resulting in insufficient flexibility of the pressure-sensitive adhesive and insufficient adjustability to a gap with the adherend. Therefore, the initial adhesion before heating at high temperatures, for example, in a reflow process, might become low. In addition, when the amount of volatile components at 150°C exceeds 80 ppm by mass, the heat conductive sheet contains excessive volatile components. As a result, the adhesion of the heat conductive layer to the adherend is likely to become low due to cells generated during heating at high temperatures.

From the above viewpoints, the amount of volatile components at 150°C is preferably 3 ppm by mass or more and 70 ppm by mass or less, and more preferably 4 ppm by mass or more and 60 ppm by mass or less.

In the heat conductive sheet of the present invention, an amount of volatile components measured by thermal desorption GC-MS at 260°C (hereinafter, also referred to as an "amount of volatile components at 260°C") is preferably 2500 ppm by mass or less. As described later, the adhesion of the heat conductive layer to the adherend is sometimes enhanced after heating at high temperatures, for example, in the reflow process. When the amount of volatile components at 260°C is 2500 mass ppm or less, however, the enhancement of the adhesion is hardly hindered with the volatile components. From such a viewpoint, the amount of volatile components at 260°C is more preferably 2300 ppm by mass or less, and still more preferably 1800 ppm by mass or less.

From the viewpoint of keeping the amount of volatile components at 150°C within a desired range, the amount of volatile components at 260°C is preferably 30 ppm by mass or more, more preferably 50 ppm by mass or more, still more preferably 70 ppm by mass or more, and even more preferably 100 ppm by mass or more, although not limited thereto.

Note that the amount of volatile components at 150°C and 260°C can be controlled to a desired range by adjusting, for example, a drying step described later, the basis weight of a pressure-sensitive adhesive layer, the type of volatile components, and curing conditions. Examples of the volatile components include volatile substances such as alkoxysilane compounds described later and diluents such as organic solvents.

The detailed procedure and measurement conditions for thermal desorption GC-MS are as described in Examples.

### (Pressure-sensitive Adhesive Property)

The heat conductive sheet of the present invention has pressure-sensitive adhesive properties on at least one surface thereof. The heat conductive sheet may also have pressure-sensitive adhesive properties on only one surface or both surfaces thereof. As described later, the heat conductive sheet may include a pressure-sensitive adhesive layer on at least one surface of the heat conductive layer or contain a pressure-sensitive adhesive in the heat conductive layer to impart pressure-sensitive adhesive properties to the surface of the heat conductive layer, whereby the surface of the heat conductive sheet has pressure-sensitive adhesive properties. The pressure-sensitive adhesive force of at least one surface of the heat conductive sheet, i.e., the heat conductive layer is preferably 2 N or more, more preferably 2.5 N or more, still more preferably 3 N or more, even more preferably 4 N or more. A pressure-sensitive adhesive force equal to or greater than the lower limit indicates good pressure-sensitive adhesive properties. The pressure-sensitive adhesive force is practically, for example, 10 N or less, preferably 9.5 N or less, and more preferably 9 N or less, although not limited thereto.

Note that the pressure-sensitive adhesive force is measured with a tack test and is also referred to as a tack value. The detailed procedure thereof is as described in Examples.

Preferably, at least one surface of the heat conductive sheet, which has pressure-sensitive adhesive, loses pressure-sensitive adhesive properties by heating at 260°C for 3 minutes. As used herein, the expression "losing pressure-sensitive adhesive properties " means that when the heat conductive sheet is adhered to an adherend and then heated under conditions of 260°C for 3 minutes, at least one surface thereof loses viscosity due to curing or the like and has such adhesive properties that the heat conductive sheet cannot peel from the adherend. Since the heat conductive sheet has the property of losing pressure-sensitive adhesive properties, it can tightly adhere to an adherend with high adhesive force without peeling off after heating at high temperatures.

Whether or not the heat conductive sheet loses pressure-sensitive adhesive properties may be determined by, for example, the following method: The heat conductive sheet is heated under conditions of 260°C for 3 minutes and then cooled to 23°C. When a tack value is 1.5 N or less as measured for the heat conductive sheet in a 23°C environment, it can be determined that the pressure-sensitive adhesive properties have been lost.

Although not limited in the present invention, the pressure-sensitive adhesive layer may have the property of losing pressure-sensitive adhesive properties by heating at 260°C for 3 minutes when it is an acrylic pressure-sensitive adhesive layer and has a reactive double bond, as described later.

In this case, the pressure-sensitive adhesive properties are lost due to a reaction of the reactive double bond by heating; when it is in contact with an adherend, the pressure-sensitive adhesive layer forms a chemical bond with the adherend along with the reaction and thus has an increased adhesive force with the adherend. At the same time, the pressure-sensitive adhesive layer is cured to increase the mechanical strength. Therefore, it is considered that peeling of the heat conductive sheet from the adherend is less likely to occur during heating at high temperatures in the reflow process or the like.

### (Polymer Matrix)

The polymer matrix is a matrix formed of an organic polymer, such as an elastomer and rubber, and is preferably a product formed by curing a liquid polymer composition (curable polymer composition) of a mixed system, such as a base resin and a curing agent. The curable polymer composition may be composed of, for example, uncrosslinked rubber and a crosslinking agent, or may contain a monomer, a prepolymer or the like, and a curing agent or the like. In addition, the curing reaction may be room temperature curing or heat curing.

The polymer matrix is preferably organopolysiloxane. In the present invention, the use of organopolysiloxane can make the polymer matrix flexible after curing and enhance filling properties of a heat conductive filler. The organopolysiloxane is preferably silicone rubber. In addition, the organopolysiloxane is preferably curable silicone, and more preferably addition-reaction type silicone.

In the case of the addition-reaction type silicone, the curable polymer composition may be composed of an alkenyl group-containing organopolysiloxane (base resin) and a hydrogenorganopolysiloxane (curing agent), and the polymer matrix may be obtained by curing these components. It is considered that the use of the addition-reaction type silicone facilitate the enhancement of adhesion to an adherend by heating at high temperatures, for example, in a reflow process.

As the rubber, various synthetic rubbers other than silicone rubber can be used. Specific examples thereof include acrylic rubber, nitrile rubber, isoprene rubber, urethane rubber, ethylene propylene rubber, styrene-butadiene rubber, butadiene rubber, fluororubber, and butyl rubber. When any of these rubbers is used, the synthetic rubber may be crosslinked or left uncrosslinked (that is, uncured) in the heat conductive sheet. Uncrosslinked rubber is used mainly in flow orientation.

When the synthetic rubber is crosslinked (that is, cured), the polymer matrix may be, as described above, a product obtained by curing a curable polymer composition composed of an uncrosslinked rubber selected from any of these synthetic rubbers and a crosslinking agent.

As the elastomer, a thermoplastic elastomer, such as a polyester-based thermoplastic elastomer or a polyurethane-based thermoplastic elastomer, or a thermosetting elastomer formed by curing a liquid polymer composition of a mixed system composed of a base resin and a curing agent can be used. The elastomer is, for example, a polyurethane-based elastomer formed by curing a polymer composition containing a polymer having a hydroxy group and isocyanate.

The polymer composition for forming the polymer matrix may be a composition composed of an organic polymer alone or a mixture containing a plasticizer or a polymeric dispersant in addition to the organic polymer. The plasticizer is suitably used when synthetic rubber is used. When the plasticizer is contained, the flexibility of the uncrosslinked polymer matrix can thereby be enhanced. For example, when the polymer matrix is organopolysiloxane, silicone oil may be used as the plasticizer. As the polymeric dispersant, for example, an alkoxysiloxane compound, an aromatic ring-containing siloxane compound, or a siloxane compound having a hydroxy group, which will be described later, may be used. In other words, the curable polymer composition may be composed of a base resin and curing agent or may contain a plasticizer or a polymeric dispersant in the base resin and the curing agent. In addition, a curable polymer composition containing a base resin, a curing agent, and a polymeric dispersant is particularly preferable from the viewpoint of preventing the amount of volatile components from becoming excessively large and the viewpoint of adjusting the viscosity of the composition to be low to facilitate high filling of a heat conductive filler described later.

The alkoxysiloxane compound to be used as the polymeric dispersant has a structure having two or more siloxane bonds (also referred to as a siloxane backbone) in which an alkoxy group is bonded to at least one silicon atom. The alkoxysiloxane compound has a structure in which an organic substituent is bonded to at least one of the silicon atoms forming the siloxane bonds. The alkoxysiloxane compound has an alkoxy group and an organic substituent, which can enhance compatibility with the organopolysiloxane that makes up the curable polymer composition. The number n of repeating units in the siloxane backbone is preferably 11 or more. The number n of repeating units in the siloxane backbone (-Si-O-) is preferably 11 or more and 350 or less, more preferably 20 or more and 300 or less, still more preferably 50 or more and 270 or less, and still more preferably 100 or more and 250 or less. When the number n of repeating units in the siloxane backbone is equal to or greater than the lower limit, compatibility with the organopolysiloxane forming the matrix is enhanced, and an increase in the amount of volatile components can be suppressed. When the number n of repeating units in the siloxane backbone is equal to or less than the upper limit, the viscosity of the composition is easily adjusted to be low.

Examples of the alkoxy group and the organic substituent contained in the alkoxysiloxane compound include groups illustrated in the description of the alkoxysilane compound above. From the viewpoint of compatibility with the organopolysiloxane that makes up the curable polymer composition, the alkoxysiloxane compound preferably has at least at alkyl group.

Examples of the alkoxysiloxane compound include a methylmethoxysiloxane oligomer, a methylphenylmethoxysiloxane oligomer, a methylepoxymethoxysiloxane oligomer, a methylmercaptomethoxysiloxane oligomer, and a methylacryloylmethoxysiloxane oligomer.

One or more alkoxysiloxane compounds can be used.

As the polymeric dispersant, an aromatic ring-containing siloxane compound having a structure represented by the following formula (1) can also be used.

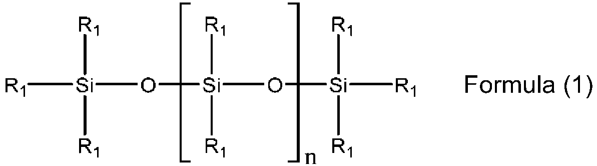

In formula (1), each R₁ is independently a group represented by A-B or a monovalent hydrocarbon group having 1 to 4 carbon atoms, and at least one R₁ of a plurality of R₁ represents a group represented by A-B. A represents a divalent organic group bonded to a silicon atom. B has 3 or more and 6 or less conjugated aromatic 6-membered rings. In the case where, among atoms making up A, the atom bonded to the aromatic 6-membered ring present in B is defined as an atom at the α-position, the atom bonded to the atom at the α-position as an atom at the β-position, and the atom bonded to the atom at the β-position other than the atom at the α-position as an atom at the γ-position, any one of the atoms at the α-position, the β-position, and the γ-position is a heteroatom; and n is an integer of 1 or more. Note that A may also have a heteroatom in a moiety other than the atom at the α-position, the atom at the β-position, and the atom at the γ-position.

Examples of the heteroatom herein include, but are not limited to, an oxygen atom, a nitrogen atom, a sulfur atom, and a boron atom, among which an oxygen atom is preferable from the viewpoint of effectively enhancing the fluidity of a polysiloxane phosphor.

The aromatic ring-containing siloxane compound having a structure represented by formula (1) has 3 or more and 6 or less conjugated aromatic 6-membered rings and includes a large conjugated moiety in the molecular structure. Therefore, the aromatic ring-containing siloxane compound is highly adsorptive to the heat conductive filler having π electrons due to π-π interaction, and thus easily disperses the heat conductive filler.

A preferably represents a divalent organic group having 11 or less carbon atoms, and more preferably a divalent organic group having 10 or less carbon atoms. As described above, an aromatic ring-containing siloxane compound with a certain number of carbon atoms or less of A is preferable because the aromatic ring-containing siloxane compound easily enhances the dispersing ability of the heat conductive filler. The lower limit of the number of carbon atoms of A is not limited, but A preferably represents a divalent organic group having 4 or more carbon atoms.

In addition, A has a heteroatom as described above, and therefore has a structural unit having a heteroatom. Examples of the structural unit include an ether, an ester, an amide, a urethane, a thioether, and a thioester, among which an ether or an ester is preferable, an ether is more preferable, and a cyclic ether is particularly preferable from the viewpoint of enhancing the dispersing ability with respect to the heat conductive filler and enhancing the fluidity. Note that a cyclic ether is an ether having a structure in which carbon of a cyclic hydrocarbon is replaced by oxygen.

Moreover, A preferably has a cyclic ether structure represented by the following formula (5-1) or an ester backbone represented by the following formula (5-2) from the viewpoint of enhancing the dispersing ability of the heat conductive filler and enhancing the fluidity.

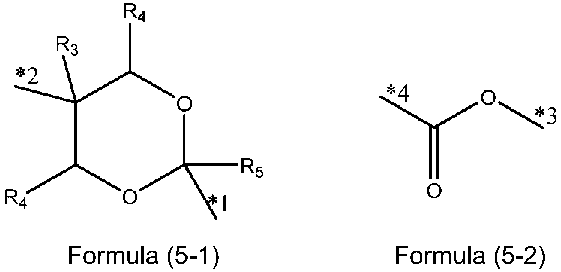

In formula (5-1), *1 and *2 each represent a bonding, and R₄ is a hydrogen atom or a hydrocarbon group having 1 to 4 carbon atoms, preferably a hydrogen atom. Two R₄ may be the same as or different from each other. R₃ is a hydrogen atom or a hydrocarbon group having 1 to 4 carbon atoms, preferably a hydrocarbon group having 1 to 4 carbon atoms, more preferably a hydrocarbon group having 1 to 3 carbon atoms, and still more preferably an ethyl group. R₅ is a hydrogen atom or a hydrocarbon group having 1 to 4 carbon atoms, preferably a hydrogen atom. The oxygen atom in formula (5-1) is the above-described atom at the β-position or the γ-position, preferably the atom at the β-position.

In formula (5-2), *3 and *4 each represent a bonding. An oxygen atom having a bonding of *3 is the above-described atom at the α-position, the β-position, or the γ-position.

Among the above, A preferably has a backbone represented by formula (5-1).

Furthermore, A preferably has a structure represented by any one of the following formulas (6) to (10) from the viewpoint of enhancing the dispersing ability of the heat conductive filler and enhancing the fluidity, and more preferably has a structure represented by any one of the following formulas (6) and (7).

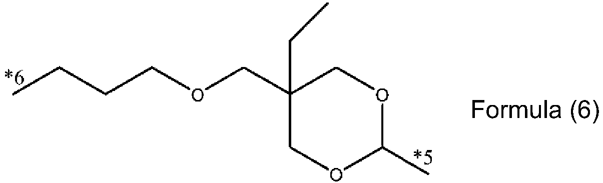

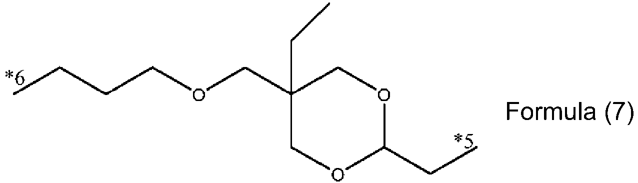

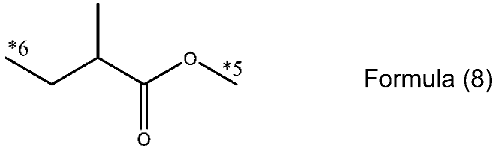

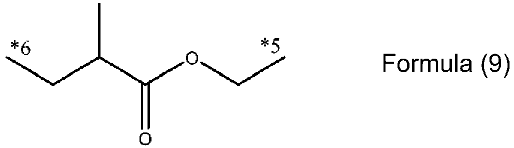

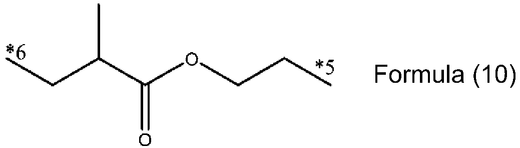

In formulae (6) to (10), *5 represents a bonding bonded to the aromatic 6-membered ring of B, and *6 represents a bonding bonded to the silicon atom of formula (1).

In formula (1), B has 3 or more and 6 or less conjugated aromatic 6-membered rings. Conjugation refers to an alternation connection of unsaturated bonds and single bonds in a molecular structure, leading to stabilization through an interaction of p orbitals, delocalization of electrons (spread throughout the conjugated system), and the like. Note that 3 or more and 6 or less conjugated aromatic 6-membered rings are included in the concept of the above-described polycyclic aromatic structure.

When the number of aromatic 6-membered rings is 6 or less, the fluidity of the aromatic ring-containing siloxane compound is enhanced. When the number of aromatic 6-membered rings is 3 or more, adsorption with the heat conductive filler is enhanced, and the dispersing ability of the heat conductive filler is enhanced.

From the viewpoint of enhancing both adsorption and fluidity with the heat conductive filler in a well-balanced manner, the number of aromatic 6-membered rings is preferably 4 or more and 5 or less.

Three or more and six or less conjugated aromatic 6-membered rings may form a fused-ring compound composed of 3 or more and 6 or less aromatic 6-membered rings or a non-fused ring compound, but a fused-ring compound is preferable. As described above, the case where B contains or represents a fused-ring compound is preferable from the viewpoint of further enhancing the adsorption to the heat conductive filler and enhancing the dispersing ability.

Examples of the fused-ring compound include anthracene, an anthracene derivative, phenanthrene, a phenanthrene derivative, triphenylene, a triphenylene derivative, pyrene, a pyrene derivative, tetracene, a tetracene derivative, picene, a picene derivative, perylene, a perylene derivative, pentaphene, a pentaphene derivative, pentacene, a pentacene derivative, hexaphene, and a hexaphene derivative, among which pyrene, a pyrene derivative, perylene, or a perylene derivative is preferable. The derivative herein means a compound having a substituent. For example, the anthracene derivative means anthracene having a substituent, and the same applies to other derivatives.

When the fused-ring compound has a substituent, at least one or more hydrogen atoms making up the fused-ring compound are replaced by a substituent. Examples of the substituent include an organic group having 1 to 10 carbon atoms.

From the viewpoint of enhancing the fluidity of the aromatic ring-containing siloxane compound of the present invention, the fused-ring compound preferably has no substituent. Therefore, B represents particularly preferably pyrene or perylene.

In the fused-ring compound, any carbon atom making up the fused ring may be bonded to A.

In the present invention, B may be any of structures described above without any limitation, and a suitable structure of B is shown below.

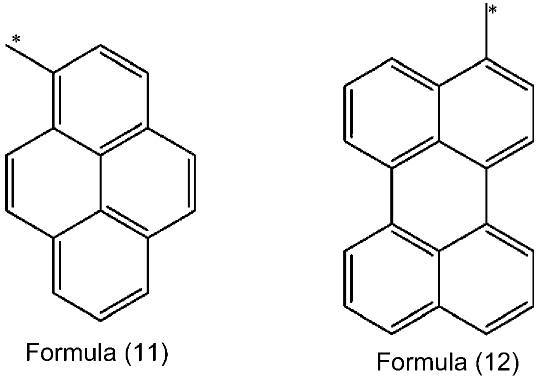

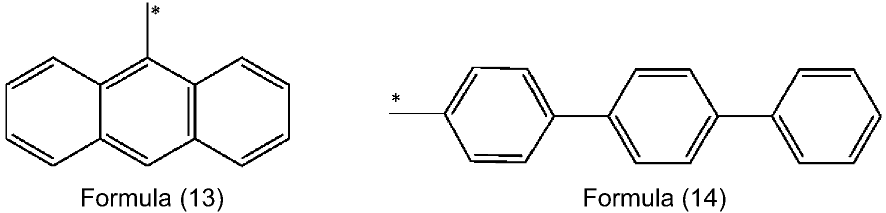

In formulas (11) to (14), * represents a bonding bonded to A.

In formulas (11) to (14), any one of the compounds represented by formulas (11) to (13), which are fused-ring compounds, is preferable, among which pyrene represented by formula (11) or perylene represented by formula (12) is more preferable, and pyrene represented by formula (11) is still more preferable.

In formula (1), at least one R₁ is a group represented by A-B, and the remaining R₁ is a hydrocarbon group having 1 to 4 carbon atoms. In formula (1), the number of groups represented by A-B among a plurality of R₁ is preferably 1 or more and 5 or less, more preferably 1 or 2, and the rest is preferably a monovalent hydrocarbon group having 1 to 4 carbon atoms. When there are a plurality of groups represented by A-B, the plurality of groups represented by A-B may be the same as or different from each other.

Examples of the monovalent hydrocarbon group having 1 to 4 carbon atoms include a methyl group, an ethyl group, a propyl group, and a butyl group, among which a methyl group is preferable. When there are a plurality of monovalent hydrocarbon groups having 1 to 4 carbon atoms, the plurality of monovalent hydrocarbon groups having 1 to 4 carbon atoms may be the same as or different from each other.

In formula (1), the number n means the number of repetitions of the siloxane backbone, and n is an integer of 1 or more. Although the number n is not limited as long as it is an integer of 1 or more, the number n is preferably 400 or less, more preferably 300 or less, and still more preferably 250 or less, and is preferably 10 or more, more preferably 40 or more, and still more preferably 200 or more. When the number n of repeating units in the siloxane backbone is equal to or greater than the lower limit, compatibility with the organopolysiloxane forming the matrix is enhanced, and an increase in the amount of volatile components can be suppressed. When the number n of repeating units in the siloxane backbone is equal to or less than the upper limit, the viscosity of the composition is easily adjusted to be low, making the fluidity good.

### (Siloxane Compound Having Hydroxy Group)

The polymeric dispersant may be a siloxane compound having a hydroxy group. The siloxane compound having a hydroxy group has a hydroxy group at a part of the end of the main chain, a side chain, or both. In other words, the siloxane compound having a hydroxy group in the present invention may be a siloxane compound having a hydroxy group at a part of the end of the main chain or a side chain or a siloxane compound having a hydroxy group at both the part of the end of the main chain and the side chain. The siloxane compound having a hydroxy group is a hydroxy group-containing siloxane compound other than the siloxane compound having a hydroxy group at both ends of the main chain. The end of the main chain herein means an end of the longest portion of the molecular chain in the molecular structure (a linear portion having the largest number of constituent atoms in the molecular structure).

The siloxane compound having a hydroxy group with a specific structure readily reacts or interacts with a functional group on the surface of the heat conductive filler due to its hydroxy group. Since the siloxane compound having a hydroxy group does not have a hydroxy group at both ends, it does not react or interact with the heat-conductive filler at both ends. Therefore, it is considered that the dispersing ability of the heat conductive filler in the composition can be enhanced, and the viscosity can be effectively reduced.

The siloxane compound having a hydroxy group according to the present invention may have only one hydroxy group or two or more hydroxy groups. The upper limit of the number of hydroxy groups is preferably 6 or less, and more preferably 3 or less, although not limited thereto. In particular, a siloxane compound having two hydroxy groups is preferable due to its high viscosity-reducing effect.

The number of hydroxy groups of the siloxane compound having a hydroxy group in the present invention may be one, and one embodiment includes a siloxane compound having a hydroxy group only at one end of the main chain.

The siloxane compound having a hydroxy group according to the present invention has a siloxane backbone (-Si-O-), and the number n of repeating units in the siloxane backbone is preferably 11 or more. The number n of repeating units in the siloxane backbone is preferably 11 or more and 350 or less, more preferably 20 or more and 300 or less, still more preferably 50 or more and 270 or less, and still more preferably 100 or more and 250 or less. When the number n of repeating units in the siloxane backbone is equal to or greater than the lower limit, compatibility with the organopolysiloxane forming the matrix is enhanced, and an increase in the amount of volatile components can be suppressed. When the number n of repeating units in the siloxane backbone is equal to or less than the upper limit, the viscosity of the composition is easily adjusted to be low.

The polymeric dispersant in the present invention is contained in a polymer composition. In the case where the total amount of the polymer composition is 100% by mass, the content of the polymeric dispersant in the polymer composition is preferably 1% by mass or more and 50% by mass or less, more preferably 2% by mass or more and 30% by mass or less, and still more preferably 3% by mass or more and 15% by mass or less from the viewpoint of effectively reducing the viscosity of the composition.

The total amount of the polymer composition as used herein means the total amount of components forming the polymer matrix, and the polymer composition contains not only an organic polymer such as an organopolysiloxane but also an additive such as a plasticizer and a dispersant, but not a component volatilizing during production or a heat conductive filler. Accordingly, the total amount of the polymer composition can also be referred to as an amount obtained by subtracting the amount of the heat conductive filler and the volatile substance blended from the total amount of a mixed composition for forming the heat conductive layer.

The content of the polymer matrix, expressed in terms of a filling factor on a volume basis (volume filling factor), is preferably 15% by volume or more and 50% by volume or less, more preferably 17% by volume or more and 46% by volume or less, and still more preferably 20% by volume or more and 42% by volume or less, based on the total amount of the heat conductive sheet.

### (Heat Conductive Filler)

The heat conductive filler contained in the heat conductive layer is preferably dispersed in and retained by the polymer matrix. Examples of the heat conductive filler include an anisotropic filler and a non-anisotropic filler, and it is preferable to use at least an anisotropic filler.

The anisotropic filler is preferably oriented in the thickness direction of the heat conductive sheet. As a result, the heat conductive layer tends to increase the thermally conductive properties. When the anisotropic filler is oriented in the thickness direction, its major axis direction need not be strictly parallel to the thickness direction. It is assumed that the anisotropic filler is oriented in the thickness direction even when the major axis direction is slightly inclined with respect to the thickness direction. Specifically, an anisotropic filler in which the major axis direction is inclined by less than 20° is also regarded as being oriented in the thickness direction, and such an anisotropic filler is assumed to be oriented in the thickness direction when it constitute the majority (for example, more than 60%, preferably more than 80% of the total number of anisotropic fillers) in the heat conductive sheet.

The content of the heat conductive filler is preferably 150 parts by mass or more and 3000 parts by mass or less, more preferably 200 parts by mass or more and 1800 parts by mass or less, and still more preferably 300 parts by mass or more and 1000 parts by mass or less, based on 100 parts by mass of the polymer matrix. When the content of the heat conductive filler is 150 parts by mass or more, a certain level of thermally conductive properties can be imparted to the heat conductive layer. When the content is 3000 parts by mass or less, the heat conductive filler can be properly dispersed in the polymer matrix. In addition, it is possible to prevent the viscosity of a mixed composition described later from becoming higher than necessary.

The volume filling factor of the heat conductive filler based on the total amount of the heat conductive layer is preferably 40% by volume or more and 85% by volume or less, more preferably 48% by volume or more and 83% by volume or less, and still more preferably 56% by volume or more and 80% by volume or less. When the volume filling factor of the heat conductive filler is equal to or greater than the lower limit, a certain level of thermally conductive properties can be imparted to the heat conductive layer. Furthermore, a volume filling factor of the heat conductive filler equal to or less than the upper limit facilitates the manufacture of the heat conductive layer.

### (Anisotropic Filler)

The anisotropic filler is a filler having anisotropy in shape that can be oriented. Examples of the anisotropic filler include a fibrous material and a flake-like material. The anisotropic filler has a high aspect ratio, specifically an aspect ratio of more than 2, preferably 5 or more. When the aspect ratio is larger than 2, the anisotropic filler is easily oriented in the thickness direction, making it easy to increase the thermally conductive properties of the heat conductive layer in one direction such as the thickness direction. The upper limit of the aspect ratio is practically 100, although not limited thereto.

Note that the aspect ratio refers to a ratio of the length in the major axis direction to the length in the minor axis direction of the anisotropic filler. For a fibrous material, the aspect ratio means fiber length/size of the fiber, and for a flake-like material, the aspect ratio means length/thickness in the major axis direction of the flake-like material.

The content of the anisotropic filler in the heat conductive layer is preferably 10 parts by mass or more and 500 parts by mass or less, more preferably 30 parts by mass or more and 300 parts by mass or less, and still more preferably 50 parts by mass or more and 250 parts by mass or less, based on 100 parts by mass of the polymer matrix.

When the content of the anisotropic filler is 10 parts by mass or more, the thermally conductive properties are easily enhanced. When the content is 500 parts by mass or less, the viscosity of the mixed composition described later tends to be appropriate, and the orientation of the anisotropic filler becomes good. The dispersing ability of the anisotropic filler in the polymer matrix is also enhanced.

When the anisotropic filler is a fibrous material, the average fiber length is preferably 10 µm or more and 300 µm or less, more preferably 20 µm or more and 200 µm or less, and still more preferably 30 µm or more and 100 µm or less. When the average fiber length is 10 µm or more, anisotropic fillers are appropriately in contact with each other inside the heat conductive layer to secure a heat transfer path, making the thermally conductive properties of the heat conductive layer good.

On the other hand, when the average fiber length is 500 µm or less, the anisotropic filler has a reduced bulk, allowing the anisotropic filler to be filled highly in a binder component.

In addition, the average fiber length of the fibrous material is preferably shorter than the thickness of the heat conductive sheet. When the average fiber length is shorter than the thickness, the fibrous material is thereby prevented from protruding more than necessary from the surface of the heat conductive sheet.

Note that the average fiber length can be calculated by observing the anisotropic filler with a microscope. More specifically, the fiber lengths of 50 arbitrary anisotropic fillers are measured using, for example, an electron microscope or an optical microscope, and the average value (arithmetical mean value) can be taken as the average fiber length.

When the anisotropic filler is a flake-like material, the average particle diameter is preferably 5 µm or more and 1000 µm or less, more preferably 8 µm or more and 750 µm or less, and still more preferably 10 µm or more and 500 µm or less. In particular, when the orientation method described later is a magnetic field orientation technique, the average particle diameter is preferably 5 µm or more and 300 µm or less, more preferably 8 µm or more and 200 µm or less, and still more preferably 10 µm or more and 100 µm or less. When the average particle diameter is 5 µm or more, anisotropic fillers are easily in contact with each other in the heat conductive layer to secure a heat transfer path, making the thermally conductive properties of the heat conductive layer good. On the other hand, when the average particle diameter is 300 µm or less, the heat conductive sheet has a reduced bulk, allowing for high filling of the anisotropic filler in a binder component.

When the orientation technique is a flow orientation technique, the average particle diameter of the flake-like material is preferably 5 µm or more and 1000 µm or less, more preferably 10 µm or more and 750 µm or less, and still more preferably 15 µm or more and 500 µm or less. When the average particle diameter is 5 µm or more, anisotropic fillers are easily in contact with each other in the heat conductive layer to secure a heat transfer path, making the thermally conductive properties of the heat conductive layer good. On the other hand, when the average particle diameter is 1000 µm or less, the heat conductive sheet has a reduced bulk, allowing for high filling of the anisotropic filler in a binder component.

Note that the average particle diameter of a flake-like filler is represented by D50, which can be calculated by observing the flake-like filler with a microscope and taking the major axis as the diameter. More specifically, the D50 refers to a particle diameter corresponding to a cumulative frequency of 50%, whose measurement is taken from the major axis of 500 or more arbitrary flake-like fillers using, for example, an electron microscope or an optical microscope. Specifically, the D50 can be determined from a particle diameter distribution curve, where the horizontal axis represents the particle diameter and the vertical axis represents the cumulative frequency, using the flake-lake filler as a sample. The particle diameter distribution curve is a number-based particle diameter distribution curve to be obtained in sequential cumulation from a flake-like filler having the smallest particle size.

As the anisotropic filler, a known material having thermally conductive properties may be used. As described later, the anisotropic filler may have diamagnetism in the case of being oriented by magnetic field orientation. On the other hand, the anisotropic filler may not have diamagnetism in the case of being oriented by flow orientation or not oriented.

Specific examples of the anisotropic filler include a carbon-based material represented by carbon fiber or flake-like carbon powder, a metal material represented by metal fiber, a metal oxide, boron nitride, a metal nitride, a metal carbide, a metal hydroxide, and a polyparaphenylene benzoxazole fiber, among which a carbon-based material has a small specific gravity and the good dispersing ability into the binder component and is therefore preferable. In particular, a graphitized carbon material with high thermal conductivity is more preferable. When including graphite planes uniformly facing a predetermined direction, a graphitized carbon material has diamagnetism.

Boron nitride is also preferable as the anisotropic filler. Boron nitride is preferably used as, but not limited to, a flake-like material. Flake-like boron nitride may be agglomerated or may not agglomerated, but a part or the whole thereof is preferably non-agglomerated. Note that when including crystal planes uniformly facing in a predetermined direction, boron nitride and the like also have diamagnetism.

The anisotropic filler has a thermal conductivity of generally 30 W/m·K or more, preferably 60 W/m·K or more, more preferably 100 W/m·K or more, and still more preferably 200 W/m·K or more along a direction of having anisotropy (i.e., major axis direction), although not limited thereto. The thermal conductivity of the anisotropic filler is, for example, 2000 W/m·K or less, although the upper limit thereof is not limited. The thermal conductivity can be measured by laser flash analysis or the like.

The anisotropic filler may be used alone or in combination with two or more thereof. As the anisotropic filler, for example, at least two anisotropic fillers each having a different average particle diameter or average fiber length may be used. It is considered that relatively smaller anisotropic fillers get into a gap among relatively larger anisotropic fillers and the anisotropic fillers are filled at a high density in the binder component and heat-conducting efficiency is enhanced by using anisotropic fillers, each of which has a different size.

In addition, the anisotropic filler preferably contains a fibrous material among the above. When a heat conductive layer containing fibrous material is sliced as described later, the layer is likely to have poor adhesion due to the loss of the fibrous material and resultant unevenness on the surface. In the present invention, however, a pressure-sensitive adhesive or pressure-sensitive adhesive layer gets in a depression of the surface, for example, when the heat conductive layer is impregnated with the pressure-sensitive adhesive or when the pressure-sensitive adhesive layer is provided on at least one surface of the heat conductive layer. Thus, even the heat conductive layer having fibrous material is able to have sufficiently enhanced adhesion.

From the viewpoint of enhancing the thermally conductive properties, the heat conductive layer preferably contains a flake-like material as an anisotropic filler in addition to the fibrous material. In this case, the content ratio of the flake-like material to the fibrous material (flake-like material/fibrous material) on a mass basis is, for example, 0.01 or more and 1 or less, preferably 0.02 or more and 0.5 or less, and more preferably 0.1 or more and 0.3 or less.

The carbon fiber to be used as the anisotropic filler is preferably a graphitized carbon fiber. In addition, the flake-like carbon powder is preferably flake-like graphite powder. It is also preferable to use graphitized carbon fiber and flake-like graphite powder in combination as the anisotropic filler.

Graphitized carbon fiber features a series of crystal planes of graphite connected in the fiber axis direction and has a high thermal conductivity in the fiber axis direction. Therefore, aligning the fiber axis direction in a predetermined direction enables thermal conductivity in a specific direction to be increased. Flake-like graphite powder features a series of crystal planes of graphite connected in the in-plane direction of flake planes and has a high thermal conductivity in the in-plane direction. Therefore, aligning the flake planes in a predetermined direction enables thermal conductivity in a specific direction to be increased. The graphitized carbon fiber and the flake graphite powder preferably have a high degree of graphitization.

The following raw materials graphitized are available for the above-described graphitized carbon materials, such as graphitized carbon fiber and flake-like graphite powder. Examples thereof include fused polycyclic hydrocarbon compounds such as naphthalene, and fused heterocyclic compounds such as polyacrylonitrile (PAN) and pitch. In particular, graphitized mesophase pitch having a high degree of graphitization, polyimide, and polybenzazole are preferably used. For example, by using mesophase pitch, the pitch becomes oriented in the fiber axis direction due to its anisotropy in a spinning step described later, and graphitized carbon fiber having excellent thermally conductive properties in the fiber axis direction becomes available.

The use of the mesophase pitch in the graphitized carbon fiber in an aspect is not limited as long as it is spinnable. The mesophase pitch may be used alone or in combination with another raw material, provided that the mesophase pitch to be used alone, that is, graphitized carbon fiber having a mesophase pitch content of 100% is most preferable in terms of increasing thermal conduction, spinnability, and quality stability.

The graphitized carbon fiber obtained such that, to raw materials, treatments of spinning, infusibilization, and carbonization are conducted in sequence, and pulverization or cutting is conducted to a predetermined particle diameter, and thereafter graphitization is conducted, or the graphitized carbon fiber such that carbonization is conducted, pulverization or cutting is then conducted, and thereafter graphitization is conducted can be used. When pulverization or cutting is conducted before graphitization, a condensation polymerization and a cyclization reaction progress easily during the graphitization treatment on a surface newly exposed due to pulverization, and therefore a graphitized carbon fiber having thermal conductive properties further enhanced by enhancing the degree of graphitization can be obtained. When, on the other hand, pulverization is conducted after graphitizing a spun carbon fiber, the carbon fiber after graphitization is rigid and therefore is easily pulverized, so that a carbon fiber powder having a relatively narrow fiber length distribution can be obtained by brief pulverization.

As described above, the average fiber length of the graphitized carbon fiber is preferably 10 µm or more and 300 µm or less, more preferably 20 µm or more and 200 µm or less, and still more preferably 30 µm or more and 100 µm or less. In addition, the aspect ratio of the graphitized carbon fiber exceeds 2 as described above, and is preferably 5 or more. The thermal conductivity of the graphitized carbon fiber is not limited, but the thermal conductivity in the fiber axis direction is preferably 400 W/m·K or more, and more preferably 800 W/m·K or more.

When the heat conductive layer contains an anisotropic filler, the anisotropic filler may or may not be exposed on the surface of the heat conductive layer, and is preferably exposed. Exposure of the anisotropic filler allows the anisotropic filler to be in contact with an adherend, such as a heating element or a heat sink, which facilitates lowering a thermal resistance value. In addition, the exposure of the anisotropic filler makes it hard to enhance the adhesion to the adherend. Even in such a case, however, in the present invention, a pressure-sensitive adhesive or a pressure-sensitive adhesive layer is provided to facilitate the enhancement of the adhesion.

### (Non-anisotropic Filler)

The heat conductive filler in the present invention may contain a non-anisotropic filler, and it is preferable to use the above-described anisotropic filler and non-anisotropic filler in combination.

In particular, when the non-anisotropic filler is used in combination with anisotropic fillers oriented in one direction, such as the thickness direction, the non-anisotropic filler is interposed in the gap among the oriented anisotropic fillers, thereby further enhancing thermally conductive properties. The non-anisotropic filler, a filler having substantially no anisotropy in shape, is not oriented in a predetermined direction, even in an environment where the anisotropic filler is oriented in the predetermined direction, such as under the generation of magnetic field lines or the action of shear force as described later.

The non-anisotropic filler has an aspect ratio of 2 or less, preferably 1.5 or less. When a non-anisotropic filler having such a low aspect ratio is used in combination with anisotropic fillers, the non-anisotropic filler is likely to be disposed in the gap among the anisotropic fillers, which facilitates the enhancement of the thermal conductivity. In addition, when the aspect ratio is 2 or less, it is possible to prevent an increase in the viscosity of a mixed composition described later and to achieve high filling.

Specific examples of the non-anisotropic filler include a metal, a metal oxide, a metal nitride, a metal hydroxide, a carbon material, and an oxide, a nitride, and a carbide other than a metal. Examples of the shape of the non-anisotropic filler include spherical, polyhedral, and amorphous powder.

In the non-anisotropic filling material, examples of the metal include aluminum, copper, and nickel, examples of the metal oxide include aluminum oxide represented by alumina, magnesium oxide, and zinc oxide, and examples of the metal nitride include aluminum nitride. Examples of the metal hydroxide include aluminum hydroxide. Furthermore, examples of the carbon material include spherical graphite. Examples of the oxide, nitride, and carbide other than the metal include quartz, boron nitride and silicon carbide.

Among them, aluminum oxide and aluminum are preferable because they have high thermal conductivity and are readily available in spherical shape.

The non-anisotropic filler described above may be used alone or in combination with two or more thereof.

The average particle diameter of the non-anisotropic filler is, for example, 0.1 µm or more and 200 µm or less, preferably 0.5 µm or more and 100 µm or less, and more preferably 1 µm or more and 70 µm or less.

In the case of using the non-anisotropic filler in combination with an anisotropic filler, the average particle diameter of the non-anisotropic filler is preferably 0.1 µm or more and 50 µm or less, more preferably 0.5 µm or more and 35 µm or less, and still more preferably 1 µm or more and 15 µm or less. When the average particle diameter is 50 µm or less, the non-anisotropic filler does not cause defects such as disturbing the orientation of an anisotropic filler, even when used in combination with the anisotropic filler. When the average particle diameter is 0.1 µm or more, the specific surface area of the non-anisotropic filler does not become unnecessarily large, and the viscosity of the mixed composition hardly increases even when blended in a large amount, facilitating high filling of the non-anisotropic filler.

As the non-anisotropic filler, for example, at least two non-anisotropic fillers each having a different average particle diameter may be used.

Note that the average particle diameter of the non-anisotropic filler can be measured by observation with an electron microscope or the like. More specifically, the particle sizes of 500 arbitrary non-anisotropic fillers are measured using, for example, an electron microscope or an optical microscope to determine D50 in the same manner as for the flake-like filler.

The content of the non-anisotropic filler is preferably 50 parts by mass or more and 2500 parts by mass or less, more preferably 100 parts by mass or more and 1500 parts by mass or less, and still more preferably 200 parts by mass or more and 750 parts by mass or less, based on 100 parts by mass of the polymer matrix. When the content is 50 parts by mass or more, the heat conductive sheet may have enhanced thermally conductive properties. Meanwhile, when the content is 1500 parts by mass or less, the non-anisotropic filler can be properly dispersed in the binder component to obtain an effect of enhancing the thermally conductive properties corresponding to the content. In addition, it is possible to prevent the viscosity of mixed composition from unnecessarily increasing.

The mass ratio of the content of the non-anisotropic filler to the content of the anisotropic filler is preferably 0.5 or more and 15 or less, more preferably 1 or more and 10 or less, and still more preferably 1.1 or more and 7 or less, although not limited thereto. When the mass ratio is within the above range, the non-anisotropic filler can be adequately filled between the anisotropic fillers to form an efficient heat transfer path, thereby further enhancing the thermal conductive properties of the heat conductive sheet.

In the heat conductive layer, components other than the above may further be blended in the polymer matrix within a range that does not impair the function as the heat conductive layer. Specific examples thereof include at least one selected from the group consisting of a dispersant, a flame retardant, an antioxidant, a coloring agent, an anti-settling agent, and the like. In the case where, the curable polymer composition is subjected to crosslinking, curing, or the like, as described above, a crosslinking accelerator, a curing accelerator, a curing catalyst, or the like that accelerates crosslinking or curing may be blended as an additive. As the curing catalyst, a platinum catalyst may be used when the polymer matrix is organopolysiloxane.

The surface of the heat conductive layer is preferably a slice surface. When the surface of the heat conductive layer is a slice surface, the anisotropic filler or the like can be easily exposed to the surface of the heat conductive layer as described above, thereby effectively lowering the thermal resistance value. The heat conductive sheet may have a slice surface on one surface thereof or a slice surface on both surfaces, and it is preferable that the pressure-sensitive adhesive surface, especially the surface on which the pressure-sensitive adhesive layer is provided, is a slice surface. As described later, the slice surface is formed by cutting with a shear blade, a laser, or the like.

Although the slice surface is often in a highly uneven state due to the protrusion or detachment of the anisotropic filler, filling the depression with a pressure-sensitive adhesive layer can reduce an air layer during use, thereby enhancing the adhesion while enhancing the thermal resistance value.

In addition. the surface of the heat conductive sheet is preferably a polished surface. When at least one surface of the heat conductive sheet is a polished surface, the thermal resistance value can be more effectively lowered. Although the heat conductive sheet may have a polished surface on one surface thereof or a polished surface on both surfaces thereof, the pressure-sensitive adhesive surface, especially the surface on which the pressure-sensitive adhesive layer is provided, is preferably a polished surface, particularly preferably a slice surface and a polished surface. Since the polished surface has relatively high smoothness, the adhesion to the adherend can be easily enhanced coupled with the formation of the pressure-sensitive adhesive layer.

The thickness of the heat conductive layer is, for example, about 1200 µm or less, although not limited thereto. From the viewpoint of suitable use in semiconductor applications and prevention of a large thermal resistance value, it is better to make the heat conductive layer relatively thin, and the thickness is preferably 500 µm or less, more preferably 300 µm or less, and still more preferably 200 µm or less. In addition, the thickness of the heat conductive layer is preferably 50 µm or more, more preferably 80 µm or more, and still more preferably 120 µm or more, from the viewpoint of easily enhancing the adhesion to the adherend. Note that the thickness of the heat conductive layer is an initial thickness to be measured in a state where no load is applied in the thickness direction.

The thickness of the heat conductive sheet when placed between the semiconductor chip and the heat spreader for use is preferably 200 µm or less, more preferably 150 µm or less, and still more preferably 130 µm or less, and is preferably 50 µm or more, more preferably 80 µm or more, and still more preferably 100 µm or more.

When the heat conductive layer is placed between a test head and a semiconductor package for use in a semiconductor testing process, the thickness of the heat conductive layer is preferably 2000 µm or less, more preferably 1500 µm or less, and still more preferably 1000 µm or less, from the viewpoint of enhancing heat dissipation. The lower limit of the thickness of the heat conductive layer is preferably 150 µm or more as a range applicable to semiconductor testing applications, but is not limited thereto. The thickness may be 200 µm or more or 300 µm or more.

### (Pressure-sensitive Adhesive Layer)

The heat conductive sheet of the present invention preferably includes a pressure-sensitive adhesive layer on at least one surface of the heat conductive layer. In this case, the heat conductive sheet may have pressure-sensitive adhesive properties on at least one surface of the heat conductive layer with a pressure-sensitive adhesive layer. Then, the heat conductive layer whose surface is made pressure-sensitive adhesive by the pressure-sensitive adhesive layer may be used as the heat conductive sheet or may be placed on the surface of the heat conductive sheet to make the surface of the heat conductive sheet pressure-sensitive adhesive as described above.

The pressure-sensitive adhesive layer may be provided on only one surface of the heat conductive layer or both surfaces of the heat conductive layer. As a result, both surfaces of the heat conductive sheet may have pressure-sensitive adhesive properties. As the pressure-sensitive adhesive layer, an acrylic pressure-sensitive adhesive layer, a rubber pressure-sensitive adhesive layer, a urethane pressure-sensitive adhesive layer, a silicon pressure-sensitive adhesive layer, or the like can be used, among which an acrylic pressure-sensitive adhesive layer is preferable. By use of an acrylic pressure-sensitive adhesive layer, the adhesion to the adherend such as a heat spreader, a heat sink, and a semiconductor chip tends to be increased before and after heating at high temperatures, for example, in a reflow process.

The acrylic pressure-sensitive adhesive layer is formed from an acrylic pressure-sensitive adhesive. The acrylic pressure-sensitive adhesive may contain an acrylic-based polymer as a base resin of the pressure-sensitive adhesive. The acrylic pressure-sensitive adhesive layer can exhibit pressure-sensitive adhesive properties by containing an acrylic-based polymer.

The acrylic pressure-sensitive adhesive layer may or may not have a reactive double bond, and preferably has a reactive double bond. When the acrylic pressure-sensitive adhesive layer has a reactive double bond, the reactive double bond undergoes a reaction or the like by heating at a high temperature, thereby enhancing the adhesive force to the adherend while eliminating the pressure-sensitive adhesive properties. Therefore, even when the heat conductive sheet is adhered to the adherend, such as a heat spreader or semiconductor chip, and heated to a high temperature, for example, in the reflow process, the heat conductive sheet can remain tightly adhered, preventing it from peeling from the adherend. Even when used in an environment at a relatively high temperature of, for example, about 150°C in practical use, the heat conductive sheet can maintain high adhesion.

The reactive double bond is an unsaturated carbon-carbon double bond that does not form an aromatic ring, which is typically composed of a group having a structure represented by H₂C = CH-* or H₂C = CCH₃-* (where * represents a bonding). Specific examples thereof include a vinyl group, an acryloyl group, and a methacryloyl group.

The acrylic-based polymer having a reactive double bond (reactive double bond-containing acrylic-based polymer) may have a functional group such as a hydroxy group, a carboxyl group, an epoxy group, or an amino group in the side chain in addition to the reactive double bond, and preferably has at least one of a hydroxy group or a carboxyl group in a side chain, still more preferably both a hydroxy group and a carboxyl group.

The reactive double bond-containing acrylic-based polymer can be obtained, for example, by reacting an acrylic polymer having a functional group such as a hydroxy group, a carboxyl group, an epoxy group, or an amino group in a side chain (hereinafter also referred to as an acrylic polymer (X)) with a reactive double bond-containing compound having a reactive group that reacts with the functional group and a reactive double bond (hereinafter also referred to as a reactive double bond-containing compound (Y)).

The acrylic polymer (X) may contain a (meth)acrylate-derived structural unit, typically an alkyl (meth)acrylate-derived structural unit as the main component. More specifically, examples of the acrylic polymer (X) include a copolymer of an alkyl (meth)acrylate and a functional group-containing monomer, and a copolymer of an alkyl (meth)acrylate, a functional group-containing monomer, and another monomer other than the above.

Note that (meth)acrylate is used as a term meaning one or both of acrylate and methacrylate, and the same applies to another similar term.

The alkyl (meth)acrylate is an ester of (meth)acrylic acid and alkyl alcohol. The alkyl group in the alkyl (meth)acrylate may be linear, may have a branched structure, or may have a cyclic structure.

Examples of the alkyl (meth)acrylate include methyl (meth)acrylate, ethyl (meth)acrylate, propyl (meth)acrylate, n-butyl (meth)acrylate, isobutyl (meth)acrylate, tert-butyl (meth)acrylate, 2-ethylhexyl (meth)acrylate, n-octyl (meth)acrylate, isooctyl (meth)acrylate, isononyl (meth)acrylate, isomyristyl (meth)acrylate, stearyl (meth)acrylate, cyclohexyl (meth)acrylate, and isobornyl (meth)acrylate.

The alkyl (meth)acrylate may be used alone or in combination with two or more thereof.

The alkyl (meth)acrylate is preferably an alkyl (meth)acrylate including an alkyl group having 1 to 12 carbon atoms, more preferably contains an alkyl acrylate including an alkyl group having 2 to 8 carbon atoms. The structural unit derived from the alkyl acrylate including an alkyl group having 2 to 8 carbon atoms may be a main component in the acrylic polymer (X), and may be, for example, 50% by mass or more, preferably 60% by mass or more and 95% by mass or less, and more preferably 70% by mass or more and 90% by mass or less in the acrylic polymer (X).

Examples of the functional group in the functional group-containing monomer include a carboxyl group, a hydroxy group, an amino group, and an epoxy group as described above, among which a carboxyl group and a hydroxy group are preferable. Examples of the monomer containing a carboxyl group include (meth)acrylic acid and crotonic acid, among which (meth)acrylic acid is more preferable.

Examples of the monomer containing a hydroxy group include a (meth)acrylate having a hydroxy group, such as 2-hydroxyethyl (meth)acrylate, 2-hydroxypropyl (meth)acrylate, 3-hydroxypropyl (meth)acrylate, 2-hydroxybutyl (meth)acrylate, 4-hydroxybutyl (meth)acrylate, 5-hydroxypentyl (meth)acrylate, and 6-hydroxyhexyl (meth)acrylate, and allyl alcohol, among which a (meth)acrylate having a hydroxy group such as 2-hydroxyethyl (meth)acrylate is preferable.

The structural unit derived from the functional group-containing monomer in the acrylic polymer (X) is, for example, about 1% by mass or more and 35% by mass or less, preferably 5% by mass or more and 30% by mass or less, and more preferably 10% by mass or more and 25% by mass or less.

The functional group-containing monomer may be used alone or in combination with two or more thereof.

Examples of the other monomer include a monomer other than the alkyl (meth)acrylate and the functional group-containing monomer described above, which are not limited as long as the monomer is copolymerizable with the alkyl (meth)acrylate and the functional group-containing monomer. Specific examples thereof include a styrene derivative such as styrene, α-methylstyrene, p-methylstyrene, p-chlorostyrene, and divinylbenzene; a compound having a vinyl ester group such as vinyl acetate and vinyl propionate, N-vinylpyrrolidone, N-vinylmorpholine, (meth)acrylonitrile, N-cyclohexylmaleimide, N-phenylmaleimide, N-laurylmaleimide, N-benzylmaleimide, n-propylvinyl ether, n-butylvinyl ether, isobutylvinyl ether, and tert-butylvinyl ether. The other monomer may be used alone or in combination with two or more thereof.

The reactive double bond-containing compound (Y) is a compound having a reactive group that reacts with the above-described functional group and a reactive double bond. Examples of the reactive group include an isocyanate group, an epoxy group, a carboxyl group, and a hydroxy group, among which an isocyanate group and an epoxy group are preferable, and an isocyanate group is more preferable.

The content of the reactive double bond contained in the acrylic pressure-sensitive adhesive layer can be adjusted by the amount of the functional group included in the acrylic polymer (X) and the proportion of the functional group that reacts with the reactive double bond-containing compound (Y). The amount of the functional group contained in the acrylic polymer (X) can be adjusted by the proportion of the functional group-containing monomer used in synthesizing the acrylic polymer (X).

The acrylic-based polymer contained in the acrylic pressure-sensitive adhesive layer may be of a reactive double bond-containing acrylic-based polymer or may contain an acrylic-based polymer having no reactive double bond in addition to the reactive double bond-containing acrylic-based polymer. The acrylic-based polymer may be of an acrylic-based polymer having no reactive double bond. Examples of the acrylic-based polymer having no reactive double bond include the above-described acrylic polymer (X).

The acrylic pressure-sensitive adhesive may contain, in addition to the acrylic-based polymer described above, a component generally blended in a pressure-sensitive adhesive and may appropriately contain additives such as a crosslinking agent, a tackifier, a filler, an antioxidant, an ultraviolet ray inhibitor, a plasticizer, and a viscosity modifier.

The weight-average molecular weight of the acrylic-based polymer is, for example, about 100,000 or more and 1,200,000 or less, preferably about 200,000 or more and 1,000,000 or less, although not limited thereto. Note that the weight-average molecular weight is measured by gel permeation chromatography (GPC) and determined in terms of polystyrene.

The pressure-sensitive adhesive layer may be provided on one surface of the heat conductive layer or on both surfaces of the heat conductive layer. As used herein, the one surface or both surfaces refer to a surface along the direction perpendicular to the thickness direction of the heat conductive layer, which is also referred to as a so-called main surface.

When the pressure-sensitive adhesive layer is provided on both surfaces of the heat conductive layer, the adhesion of both surfaces of the heat conductive sheet to the adherend can be enhanced. Therefore, when used in a semiconductor application, the heat conductive sheet can tightly adhere to, for example, both a semiconductor chip and a heat spreader with a relatively high pressure-sensitive adhesive force. In addition, even when the heat conductive sheet is heated at a high temperature through a reflow process or the like in a state of being adhered to these components, it becomes easy to prevent the heat conductive sheet from peeling from both the semiconductor chip and the heat spreader.

The basis weight on each surface of the pressure-sensitive adhesive layer is, for example, 0.05 mg/cm² or more, preferably 0.1 mg/cm² or more, more preferably 0.15 mg/cm² or more, and still more preferably 0.3 mg/cm² or more, and is for example 1.5 mg/cm² or less, preferably 1.3 mg/cm² or less, more preferably 1.1 mg/cm² or less, and still more preferably 0.9 mg/cm² or less. The pressure-sensitive adhesive layer can secure a sufficient pressure-sensitive adhesive force to the adherend by setting the basis weight to a certain amount or more. In addition, the amount of volatile components at 150°C is easily adjusted to a certain level.

On the other hand, the amount of volatile components at 150°C can be easily suppressed to a certain amount or less when the basis weight is a certain level or less. In addition, the pressure-sensitive adhesive layer can prevent a thermal resistance value from decreasing, making it easier to secure good thermally conductive properties.

The pressure-sensitive adhesive layer preferably soaks into the heat conductive layer. Typically, the pressure-sensitive adhesive layer may partially soak into the heat conductive layer. As long as the pressure-sensitive adhesive layer can exhibit a pressure-sensitive adhesive force with respect to the adherend, the whole thereof may soak into the heat conductive layer. The pressure-sensitive adhesive layer soaking into the heat conductive layer can reduce the amount of the pressure-sensitive adhesive present on the surface of the heat conductive layer, and thereby suppressing deterioration in thermally conductive properties by the pressure-sensitive adhesive layer.

In addition, the heat conductive sheet can maintain high adhesion, even when the pressure-sensitive adhesive soaks into the pressure-sensitive adhesive layer. Although the principle is not clear, it is presumed that the pressure-sensitive adhesive that soaks into the heat conductive sheet, which is generally, for example, compressed and then pressurized during use, oozes out to the surface to enhance the adhesion.

The pressure-sensitive adhesive layer can be soaked into cells formed by volatilization of volatile substances as described later, thereby impregnating the heat conductive layer with an appropriate amount of the pressure-sensitive adhesive layer.

In addition, the pressure-sensitive adhesive layer may be formed so as to cover the entirety of each surface of the heat conductive layer or may be formed so as to partially cover the heat conductive layer as long as the heat conductive layer can exert pressure-sensitive adhesive force to the adherend.

Although an aspect of the pressure-sensitive adhesive layer is provided on at least one surface of the heat conductive layer has been described above, it is not always necessary to provide the adhesive layer. For example, the adhesive layer may not be provided, and at least one surface of the heat conductive layer may be made pressure-sensitive adhesive by including a pressure-sensitive adhesive in the heat conductive layer. In this case, the pressure-sensitive adhesive may be incorporated into the heat conductive layer, for example, by blending the pressure-sensitive adhesive into a mixed composition described later. Examples of the pressure-sensitive adhesive contained in the heat conductive layer include an acrylic pressure-sensitive adhesive, a rubber pressure-sensitive adhesive, a urethane pressure-sensitive adhesive, and a silicone pressure-sensitive adhesive, and among these, an acrylic pressure-sensitive adhesive is preferable. The details of the acrylic pressure-sensitive adhesive are as described above. The pressure-sensitive adhesive may be a material which has already exhibited pressure-sensitive adhesive properties in the step of blending into the mixed composition or may be a material which exhibits pressure-sensitive adhesive properties in response to an external stimulus such as heat, pressure or light without having pressure-sensitive adhesive properties in the step of blending into the mixed composition.

When the pressure-sensitive adhesive is contained in the heat conductive layer, the content of the pressure-sensitive adhesive in the heat conductive layer may be, for example, 0.1 parts by mass or more and 20 parts by mass or less, preferably 0.3 parts by mass or more and 15 parts by mass or less, more preferably 0.5 parts by mass or more and 12 parts by mass or less, based on 100 parts by mass of the polymer matrix.

### (SAT Coverage)

The heat conductive sheet of the present invention preferably has a SAT coverage when bonded through thermocompression at 150°C for 10 minutes at 30 psi (hereinafter also referred to as "SAT coverage by thermocompression bonding") of 60% or more, more preferably 70% or more, and still more preferably 80% or more. When the SAT coverage by thermocompression bonding is equal to or greater than the lower limit, the initial adhesion becomes good. The upper limit of the SAT coverage by thermocompression bonding may be 100%, practically, for example, 95%, preferably 90%, and more preferably 85%, although not limited thereto.

Note that the SAT coverage by thermocompression bonding can be obtained as described below. First, the heat conductive sheet is sandwiched between a silicon wafer and a copper plate and subjected to thermocompression bonding at 150°C for 10 minutes at 30 psi to obtain a sample. The obtained sample is subjected to scanning acoustic tomography (SAT) to obtain an image of the adhesion interface between the copper plate and the heat conductive sheet, and then the image is binarized by predetermined image processing. The SAT coverage may be obtained based on the binarized image. The detailed procedure is as described in Examples. The SAT coverage after heating at high temperatures, which will be described later, may also be determined in the same manner, except for further heating at a high temperature of 260°C for 3 minutes after pressure bonding.

The heat conductive sheet of the present invention preferably has a SAT coverage after bonded through thermocompression at 150°C for 10 minutes at 30 psi, followed by heating at a high temperature of 260°C for 3 minutes (hereinafter also referred to as "SAT coverage after heating at a high temperature") of 50% or more, more preferably 60% or more, and still more preferably 70% or more. When the SAT coverage after high-temperature heating is equal to or greater than the lower limit value, the gap between the heat conductive sheet and the adherend is small after heating at a high temperature, for example, in a reflow process, resulting in good adhesion to the adherend. The upper limit of the SAT coverage after heating at a high temperature may be 100%, practically, for example, 95%, preferably 90%, and more preferably 85%, although not limited thereto.

### (E Hardness)

A heat conductive layer of the present invention has a type E hardness (hereinafter, also referred to as "E hardness") as specified in JIS K6253 of preferably 10 or more and 80 or less, more preferably 20 or more and 70 or less, and still more preferably 30 or more and 65 or less. When the E hardness is equal to or greater than the lower limit, the mechanical strength of the heat conductive sheet is easily enhanced. When the E hardness is equal to or less than the upper limit, a certain degree of flexibility is imparted to the heat conductive sheet, which also facilitates the enhancement of adhesion to the adherend.

When the heat conductive sheet is placed between a semiconductor chip and a heat spreader for use, the E-hardness of the heat conductive layer is preferably 30 or more and 50 or less, more preferably 35 or more and 45 or less. When the E hardness is equal to or greater than the lower limit, the mechanical strength of the heat conductive sheet is easily enhanced. When the E hardness is equal to or less than the upper limit, a certain degree of flexibility is imparted to the heat conductive sheet, which also facilitates the enhancement of adhesion to the adherend.

When the heat conductive sheet is placed between a test head and a semiconductor package for use in a semiconductor testing process, the E-hardness of the heat conductive layer is preferably 30 or more and 80 or less, more preferably 40 or more and 70 or less. When the E hardness is equal to or greater than the lower limit, the mechanical strength of the heat conductive sheet is easily enhanced, and deformation of the sheet can be suppressed even in use under a high load. When the E hardness is equal to or less than the upper limit, a certain degree of flexibility is imparted to the heat conductive sheet, which also facilitates the enhancement of adhesion to the adherend.

### [Method for Producing Heat Conductive Sheet]

The heat conductive sheet of the present invention can be produced according to a method including at least the following steps 1 to 3, although the heat conductive sheet of the present invention may be produced according to a method other than the following production method:
Step 1: mixing at least a curable polymer composition and a heat conductive filler to obtain a mixed composition
Step 2: curing the mixed composition by heating to obtain a cured product
Step 3: applying a pressure-sensitive adhesive to a surface of the cured product

### (Step 1)

In step 1, a mixed composition may be obtained by mixing at least a curable polymer composition and a heat conductive filler, but the mixed composition is preferably further mixed with a volatile substance. In addition, another component such as an additive to be blended, when necessary, may be appropriately added to the mixed composition.

In step 1, as long as the above components can be mixed to obtain a mixed composition, a mixing method and mixing order thereof are not limited, and the curable polymer composition, the heat conductive filler, the volatile substance to be added when necessary, and the other component to be optionally added, when necessary, may be appropriately mixed in any order to obtain a mixed composition.

The curable polymer composition, as described above, may be composed of, for example, a base resin and a curing agent (for example, an alkenyl group-containing organopolysiloxane and a hydrogenorganopolysiloxane in an addition-reaction type silicone). In such a case, the base resin, the curing agent, the heat conductive filler, volatile substance to be optionally added when necessary, and the other component may be mixed in any order to obtain a mixed composition.

The form of the mixed composition may be either a one-liquid type or a two-liquid type in which a first agent and a second agent are used in combination. In the two-liquid type, a mixed composition is obtained by mixing the first agent and the second agent together when used.

### (Volatile Substance)

The volatile substance to be used in the present invention may be any component that volatilizes in step 2 described later. The volatile substance can be volatilized by heating during curing, thereby increasing the proportion of the heat conductive filler contained in the heat conductive sheet. In addition, the mixed composition has a reduced viscosity due to the inclusion of the volatile substance, thereby making it easy to increase the amount of the heat conductive filler blended and also orient the anisotropic filler in a predetermined direction, for example, by magnetic field orientation described later.

Furthermore, since a large number of fine cells are formed in the cured product due to the volatilization of the volatile substance, the pressure-sensitive adhesive is likely to soak into the heat conductive layer in step 3 described later.

The volatile substance is preferably a compatible substance that is compatible with or dissolves in the curable polymer composition. When the volatile substance is a compatible substance, the curable polymer composition and the volatile substance can be uniformly mixed, which makes it easier to reduce the viscosity and increase the amount of the heat conductive filler blended. Furthermore, cells formed by volatilization of the volatile substance can be made fine and uniform.

The volatile substance is preferably a substance that is liquid at normal temperature (25°C) and 1 atm.

Examples of the volatile substance include an alkoxysilane compound and a hydrocarbon-based solvent. These compounds can increase solubility or compatibility with the curable polymer composition, thus making it easier to reduce the viscosity of the mixed composition and increase the amount of the heat conductive filler blended. Further, cells formed by volatilization of the volatile substance are easily made fine and uniform.

The volatile substance may be used alone, or two or more kinds thereof may be used in combination.

As the volatile substance, an alkoxysilane compound is preferably used. The use of an alkoxysilane compound gives the surface of the heat conductive sheet obtained by curing no roughness or the like observed, resulting in a good appearance.

The alkoxysilane compound to be used as the volatile substance is a compound having a structure in which one to three of the four bonds of a silicon atom (Si) are bonded to alkoxy group(s), and the remaining bond(s) is(are) bonded to organic substituent(s). The alkoxysilane compound has an alkoxy group and an organic substituent, which can enhance compatibility with a curable polymer composition, particularly a curable polymer composition composed of organopolysiloxane.

Examples of the alkoxy group contained in the alkoxysilane compound include a methoxy group, an ethoxy group, a protoxy group, a butoxyl group, a pentoxy group, and a hexatoxy group. The alkoxysilane compound may be contained as a dimer in the curable polymer composition.

Among the alkoxysilane compounds, an alkoxysilane compound having at least one of a methoxy group and an ethoxy group is preferable from the viewpoint of availability. The number of alkoxy groups contained in the alkoxysilane compound is preferably 2 or 3, and more preferably 3, from the viewpoint of compatibility and solubility with the curable polymer composition. Specifically, the alkoxysilane compound is preferably at least one selected from the group consisting of a trimethoxysilane compound, a triethoxysilane compound, a dimethoxysilane compound, and a diethoxysilane compound.

Examples of the functional group contained in the organic substituent of the alkoxysilane compound include an acryloyl group, an alkyl group, a carboxyl group, a vinyl group, a methacryl group, an aromatic group, an amino group, an isocyanate group, an isocyanurate group, an epoxy group, a hydroxyl group, and a mercapto group. When a platinum catalyst is used as a curing catalyst for the curable polymer composition composed of organopolysiloxane, it is preferable to select and use an alkoxysilane compound that hardly affects the curing reaction of the organopolysiloxane. Specifically, when an addition-reaction type organopolysiloxane utilizing a platinum catalyst is used, the organic substituent of the alkoxysilane compound preferably contains no amino group, isocyanate group, isocyanurate group, hydroxyl group, or mercapto group.

The alkoxysilane compound preferably contains an alkylalkoxysilane compound having an alkyl group bonded to a silicon atom, that is, an alkoxysilane compound having an alkyl group as an organic substituent, from the viewpoint of compatibility with the curable polymer composition composed of organopolysiloxane. Therefore, a dialkyldialkoxysilane compound and an alkyltrialkoxysilane compound are preferable, and in particular, an alkyltrialkoxysilane compound is preferable.

The number of carbon atoms of the alkyl group bonded to the silicon atom may be, for example, 1 to 16. In a trialkoxysilane compound such as a trimethoxysilane compound or a triethoxysilane compound, the number of carbon atoms of the alkyl group is preferably 6 or more, more preferably 8 or more, and the number of carbon atoms is preferably 12 or less, more preferably 10 or less.

On the other hand, in a dialkoxysilane compound such as a dimethoxysilane compound or a triethoxysilane compound, the number of carbon atoms of the alkyl group may be 1 or more, and the number of carbon atoms is preferably 10 or less, more preferably 6 or less, and still more preferably 4 or less.

Examples of alkyl group-containing alkoxysilane compounds include methyltrimethoxysilane, dimethyldimethoxysilane, diethyldimethoxysilane, trimethylmethoxysilane, methyltriethoxysilane, dimethyldiethoxysilane, ethyltrimethoxysilane, n-propyltrimethoxysilane, di-n-propyldimethoxysilane, di-n-propyldiethoxysilane, isobutyltrimethoxysilane, isobutyltriethoxysilane, isobutyltrimethoxysilane, isobutyltriethoxysilane, n-hexyltrimethoxysilane, n-hexyltriethoxysilane, methylcyclohexyldimethoxysilane, methylcyclohexyldiethoxysilane, n-octyltrimethoxysilane, n-octyltriethoxysilane, n-decyltrimethoxysilane, and n-decyltriethoxysilane.

Among the alkyl group-containing alkoxysilane compounds, n-decyltrimethoxysilane and n-octyltriethoxysilane are more preferable from the viewpoint of compatibility with organopolysiloxane that makes up the curable polymer composition.

Examples of the hydrocarbon-based solvent to be used as the volatile substance include an aromatic hydrocarbon-based solvent. In particular, an aromatic hydrocarbon-based solvent is preferable from the viewpoint of compatibility with the curable polymer composition. Examples of the aromatic hydrocarbon-based solvent include an aromatic hydrocarbon-based solvent having about 6 to 10 carbon atoms, such as toluene, xylene, mesitylene, ethylbenzene, propylbenzene, butylbenzene, and t-butylbenzene, preferably toluene and xylene.

In the mixed composition, the content of the volatile substance is preferably 1 part by mass or more and 60 parts by mass or less based on 100 parts by mass of the curable polymer composition. When the content is 1 part by mass or more, the effect of containing the volatile substance is easily exhibited, and for example, an appropriate amount of fine cells can be formed in the polymer matrix. When the amount is 60 parts by mass or less, an effect according to the amount of the volatile substance used can be obtained. From these viewpoints, the content of the volatile substance is more preferably 1.5 parts by mass or more and 50 parts by mass or less, and still more preferably 2 parts by mass or more and 35 parts by mass or less.

Note that substantially all of the volatile substance is preferably volatilized by heating in step 2. Preferably, the volatile substance is not contained in the heat conductive sheet. As long as the amount of volatile components is within the predetermined range described above, however, the volatile substance may be contained in the heat conductive sheet in a small amount.

The details of the components other than the volatile substance in the mixed composition (that is, the curable polymer composition, the heat conductive filler, another additive, etc.) are as described above. The content of the heat conductive filler in the mixed composition is also as described above, provided that the content of each component in the above description is shown as an amount based on 100 parts by mass of the polymer matrix, but in the mixed composition, the content is an amount based on 100 parts by mass of the curable polymer composition.

### (Step 2)

Step 2 involves curing the mixed composition by heating. The temperature for heating the mixed composition is not limited as long as the curable polymer composition is curable by heating, which may be higher than room temperature (25°C), preferably 50°C or more, and more preferably 70°C or more. The heating temperature may be a temperature at which the heat conductive layer and the mixed composition do not thermally deteriorate, for example, 200°C or less, preferably 180°C or less, and more preferably 160°C or less, although not limited thereto. The heating may be performed in one stage or in two or more stages. When the heating is performed in two or more stages, the heating temperature may be within the above range at least in any stage, preferably within the above range at all stages, and it is preferable that the heating is performed at a temperature lower than the boiling point of the volatile substance at least in the first stage. In addition, the total heating time is, for example, about 10 minutes to 24 hours. When two or more stages are performed, for example, the mixed composition may be semi-cured in the first stage (primary curing), and the mixed composition may be fully cured by heating in the second and subsequent stages (secondary curing). In addition, the curing may be complete curing by primary curing, and the heating after the second stage may not be accompanied by curing.

As described later, when the formed product obtained from the mixed composition is sliced into a sheet-like formed product, it is also preferable to perform heating in the first stage and primary curing before slicing, and then further heating after slicing to perform the second and subsequent stages of heating (secondary curing). The heating after slicing facilitates the volatilization of the volatile substance in the second and subsequent stages of heating.

In the case of curing in two or more stages, heating in the first stage (primary curing) may be performed at, for example, 50°C or more and 120°C or less, preferably 60°C or more and 100°C or less, and more preferably 70°C or more and 90°C or less. Heating in the second and subsequent stages (secondary curing) may be performed at higher than primary curing, for example, 100°C or more and 200°C or less, preferably 120°C or more and 180°C or less, and more preferably 140°C or more and 160°C or less. Note that the heating time in the first stage may be, for example, about 5 minutes or more and 20 hours or less, preferably about 30 minutes or more and 12 hours or less. The heating time in the second and subsequent stages is, for example, about 10 minutes or more and 15 hours or less, preferably about 1 hour or more and 10 hours or less.

When the formed product obtained from the mixed composition is subjected to heating in the first stage at a relatively low temperature as described above, the formed product can be cured so that the volatile substance is less likely to foam to generate large cells and the volatile substance remains in the formed product.

In addition, when the formed product is sliced and then subjected to heating in the second stage at a relatively high temperature, the formed product is cured. Therefore, the space where the volatile substance has existed becomes a fine cell without foaming and generating a large cell even at a high temperature. The cell size is, for example, 1 µm or less, preferably 0.2 µm or less. The lower limit of the cell size is, for example, 0.001 µm or more, although not limited thereto.

In step 2, the mixed composition may be formed into a predetermined shape, such as a block shape or a sheet shape, and cured by heating. In addition, in step 2, when the mixed composition contains an anisotropic filler as a heat conductive filler, the anisotropic filler may be oriented in one direction and then cured by heating. The anisotropic filler can be oriented according to a magnetic field orientation technique or a flow orientation technique, but the anisotropic filler is preferably oriented according to a magnetic field orientation technique.

In the magnetic field orientation technique, the mixed composition may be injected into a mold or the like and then placed in a magnetic field to orient the anisotropic filler along the magnetic field. Then, the curable polymer composition may be cured to obtain an oriented formed product. The curing of the mixed composition may be performed under the heating conditions as described above.

The oriented formed product is preferably in the shape of a block, but may be in the shape of a sheet. The oriented formed product in the shape of a sheet may be coated with the pressure-sensitive adhesive in step 3 without being sliced. On the other hand, the oriented formed product in the shape of a block enhances orientation of the anisotropic filler.

In the magnetic field orientation technique, a release film may be placed at a portion in contact with the mixed composition inside the mold. As the release film, for example, a resin film having good releasing properties or a resin film whose one side is subjected to a releasing treatment with a releasing agent or the like is used. The use of the release film facilitates the release of the oriented formed product from the mold.

The viscosity of the mixed composition used in the magnetic field orientation technique is preferably 50 Pa·s or more and 1500 Pa·s or less for magnetic field orientation. When the viscosity is 50 Pa·s or more, the heat conductive filler is less likely to settle. In addition, since the viscosity of 1500 Pa·s or less makes the fluidity good, the anisotropic filler is properly oriented by the magnetic field without defects such as too much time required for orientation. Note that the viscosity is measured at 25°C using a rotational viscosimeter (Brookfield viscosimeter DV-E, spindle SC4-14) at a rotation speed of 5 rpm.

However, the viscosity of the mixed composition may be less than 50 Pa·s in the case where a heat conductive filler that is difficult to settle is used or an additive such as an anti-settling agent is combined.

In the magnetic field orientation technique, a magnetic field line source for applying magnetic field lines includes a superconducting magnet, a permanent magnet, and an electromagnet, and a superconducting magnet is preferable because a magnetic field with a high magnetic flux density can be generated. The magnetic flux density of the magnetic field generated from the magnetic field line sources is preferably 1 to 30 tesla. When the magnetic flux density is 1 tesla or more, the above-described anisotropic filler made of a carbon material or the like can be easily oriented. When the magnetic flux density is 30 tesla or less, the anisotropic filler can be practically produced.

In the flow orientation technique, a shear force is applied to the mixed composition to produce a primary sheet in which the anisotropic filler is oriented along the plane direction. More specifically, in the flow orientation technique, the mixed composition prepared in step 1 is first stretched flat while applying a shear force to form a sheet-like shape (primary sheet). The anisotropic filler can be oriented in the shear direction by applying a shear force. As a method of forming the sheet, for example, a coating applicator such as a bar coater or a doctor blade, or extrusion molding or ejection from a nozzle may be used to apply the mixed composition to the base material film, which is then, when necessary, dried, semi-cured, or fully cured. The thickness of the primary sheet is preferably about 50 µm or more and 5000 µm or less. In the primary sheet, the anisotropic filler is oriented in one direction along the plane direction of the sheet.

The mixed composition used in the flow orientation technique has a relatively high viscosity so that a shear force is applied when stretched in a sheet shape. Specifically, the viscosity of the mixed composition is preferably 3 Pa·s or more and 500 Pa·s or less.

The primary sheet may be used as a heat conductive sheet as it is without being formed into a block as described later. In addition, a laminated block (block-shaped oriented formed product) may be formed by laminating a plurality of primary sheets so that the orientation directions are the same, and then adhering the primary sheets to each other by hot pressing or the like while curing the primary sheets by heating when necessary.

In the case of forming a laminated block, after irradiating at least one of the surfaces of the primary sheets to be overlapped with each other with vacuum ultraviolet light, the primary sheets may be overlapped with each other. When the primary sheets are overlapped with each other through the surface irradiated with vacuum ultraviolet light, the primary sheets can be strongly adhered to each other. In addition, in the case of irradiating with vacuum ultraviolet light, the mixed composition may be fully cured when the primary sheet is prepared, and it is not necessary to cure the mixed composition by heating or the like when the primary sheets are overlapped to form a laminated block.

In the flow orientation technique, the curing of the mixed composition may also be performed under the heating conditions as described above.

As described above, when the block-shaped oriented formed product is formed, the resulting oriented formed product may be cut by slicing or the like perpendicularly to the direction in which the anisotropic filler is oriented to form a sheet-like formed product. The slicing may be performed with a shear blade or a laser, for example. In the sheet-like formed product, due to the cutting through slicing or the like, a part of a fibrous filler may be exposed from the matrix on each surface which is the cut surface. The exposed fibrous filler is mostly oriented in the thickness direction without falling down.

In step 2, however, the fibrous filler contained in the oriented formed product may be cut in accordance with the cutting of the oriented formed product by slicing or the like within a range that does not impair the effects of the present invention.

The sheet-like formed product obtained by cutting may be coated with a pressure-sensitive adhesive as it is in step 3 described later or may be further subjected to another treatment. For example, each surface, which is a slice surface, may be polished. In addition, secondary curing may be performed as described above. The secondary curing may be performed after or before polishing.

When the sheet-like formed product is polished, the surface state of the sheet-like formed product is further enhanced, thereby further reducing the thermal resistance value easily. When the sheet-like formed product is polished, the surface of the sheet can be smoothed while a certain amount of the anisotropic filler such as the fibrous filler is exposed on the surface, or the fibrous filler can be brought into a fallen state. Therefore, the surface of the heat conductive sheet is easily adhered to another member, and the surface of the sheet is easily covered with the fibrous filler in a certain area or more, whereby the thermal resistance value is easily reduced.

In the polishing, at least one surface of the obtained sheet-like formed product may be polished, and it is preferable to polish both surfaces of the sheet-like formed product. The polishing of the surface may be performed using, for example, sandpaper, a polishing film, a polishing cloth, and a polishing belt.

The sandpaper preferably has, as its characteristic, an average grain size (D50) of the abrasive grains contained therein of 0.1 µm or more and 100 µm or less, and more preferably of 1 µm or more and 60 µm or less. The grain size of abrasive grains of sandpaper is preferably #120 to 20000, preferably #300 to 15000, and more preferably #320 to 4000.

As the polishing method, a method in which, for example, polishing is conducted by allowing sandpaper to abut on the surface of the sheet-like formed product continuously in the same linear direction, polishing is conducted by reciprocating sandpaper on the surface of the thermally conductive sheet within a certain distance, polishing is conducted by rotating sandpaper in the same direction on the surface of the thermally conductive sheet, or polishing is conducted by allowing sandpaper to abut on the surface of the thermally conductive sheet in various directions can be used.

With respect to the extent of polishing, the polishing may be conducted, for example, while the surface state is being observed, but in the case of reciprocation polishing for example, 1 time or more and 300 times or less of reciprocation is preferable, more preferably 3 times or more and 250 times or less, and still more preferably 5 times or more and 100 times or less .

The polishing of the surface of the sheet-like formed product may be performed by being divided into two polishing steps. For example, after the first polishing using sandpaper having a large average grain diameter of abrasive grains, the second polishing may be performed using sandpaper having a smaller average grain diameter of abrasive grains than that in the first polishing.

### (Step 3)

In step 3, a pressure-sensitive adhesive is applied to the surface of the cured product such as the sheet-like formed product obtained in step 2, as described above.

In addition, in the present production method, it is preferable to impregnate the heat conductive layer with the pressure-sensitive adhesive, and the inside of the heat conductive layer is preferably impregnated with the pressure-sensitive adhesive only by applying the pressure-sensitive adhesive.

The pressure-sensitive adhesive can be diluted with a diluent and applied to the surface of the sheet-like formed product as a pressure-sensitive adhesive diluted solution. Dilution of the pressure-sensitive adhesive with a diluent makes it easier to impregnate the heat conductive layer with the pressure-sensitive adhesive. The diluent is not limited as long as it is a component that is liquid at 25°C and 1 atm, soluble or compatible with the pressure-sensitive adhesive, and volatilizes due to drying, which will be described later, but an organic solvent can be preferably used.

Examples of the organic solvent to be used include, but not limited to, a ketone compound such as acetone, methyl ethyl ketone, and cyclohexanone; an aromatic hydrocarbon compound such as toluene, xylene, and tetramethylbenzene; a glycol ether compound such as cellosolve, methyl cellosolve, butyl cellosolve, carbitol, methyl carbitol, butyl carbitol, propylene glycol monomethyl ether, dipropylene glycol monomethyl ether, dipropylene glycol diethyl ether, tripropylene glycol monomethyl ether, and polyethylene glycol monoethyl ether; an ester compound such as ethyl acetate, butyl acetate, butyl lactate, cellosolve acetate, butyl cellosolve acetate, carbitol acetate, butyl carbitol acetate, propylene glycol monomethyl ether acetate, dipropylene glycol monomethyl ether acetate, propylene glycol monoethyl ether acetate, and propylene glycol monopropyl ether acetate; and an aliphatic hydrocarbon compound such as hexane, octane, and decane.

From the viewpoint of performing spray coating to be described later and appropriately impregnating the heat conductive layer with the pressure-sensitive adhesive, the diluent preferably contains, as the organic solvent, any one of cellosolve acetate, butyl cellosolve acetate, carbitol acetate, butyl carbitol acetate, propylene glycol monomethyl ether acetate, dipropylene glycol monomethyl ether acetate, propylene glycol monoethyl ether acetate, propylene glycol monopropyl ether acetate, and polyethylene glycol monoethyl ether, the volatilization rate of which is not too high.

In addition to the above organic solvents, the diluent preferably further contains an organic solvent having a lower boiling point than these components, and specific examples thereof include methyl ethyl ketone, methyl isobutyl ketone, hexane, ethyl acetate, butyl acetate, and toluene.

The dilution concentration with the diluent is not limited, but may be adjusted so that the solid content concentration of the pressure-sensitive adhesive is, for example, 5% by mass or more and 50% by mass or less, preferably 8% by mass or more and 35% by mass or less, and more preferably 10% by mass or more and 25% by mass or less. When the solid content concentration is 5% by mass or more, it is possible to prevent heating more than necessary during drying and appropriately soak a predetermined amount of the pressure-sensitive adhesive into the heat conductive layer together with the organic solvent. When the solid content concentration is 50% by mass or less, it is possible to appropriately soak the pressure-sensitive adhesive into the heat conductive layer because the basis weight is not increased more than necessary while the viscosity can be adjusted so as to be easily impregnated. Furthermore, the dilution concentration within the above ranges facilitates adjustment of the amount of the volatile component at 150°C and 260°C to a predetermined range.

The amount of the pressure-sensitive adhesive soaking into the heat conductive layer can be adjusted by the viscosity, the solid content concentration, the type of the solvent, and the like. For example, in the case where it is desired to increase the amount of the pressure-sensitive adhesive soaking, the viscosity may be adjusted to be low while the solid content concentration may be adjusted to be high. In the case where it is desired to decrease the amount of the pressure-sensitive adhesive material soaking, the viscosity may be adjusted to be high while the solid content concentration may be adjusted to be low.

The method of applying the pressure-sensitive adhesive is not particularly limited, and a known application method may be adopted, but spray application is preferable. By spray coating, the basis weight does not increase more than necessary, and the pressure-sensitive adhesive can easily soak into the heat conductive layer. In addition, by spray coating and suppressing the application amount, a portion with the pressure-sensitive adhesive layer and a portion without the pressure-sensitive adhesive layer can be provided on the surface of the heat conductive layer. When spray coating is performed, it is preferable to spray a pressure-sensitive adhesive containing a quick-drying organic solvent such as ethyl acetate and a slow-drying organic solvent such as polyethylene glycol monoethyl ether or propylene glycol monomethyl ether acetate. More specifically, by containing the slow-drying organic solvent, the organic solvent is prevented from being excessively volatilized when the pressure-sensitive adhesive discharged from the spray is applied to the surface of the heat conductive layer, whereby the pressure-sensitive adhesive can easily soak into the heat conductive layer. On the other hand, in the case where the quick-drying solvent is contained, it is preferable to adjust the viscosity suitable for spraying.

The applied pressure-sensitive adhesive may be subsequently dried to volatilize the diluent. The drying temperature is preferably 60°C or more, more preferably 70°C or more, and still more preferably 80°C or more, from the viewpoint of keeping the amount of volatile components at 150°C below a certain level and facilitating the enhancement of the adhesion after heating at high temperatures, for example, in a reflow process. In addition, the drying temperature is preferably 170°C or less, more preferably 150°C or less, and still more preferably 120°C or less, from the viewpoint of keeping the amount of volatile components at 150°C above a certain level and facilitating the enhancement of the initial adhesion.

The drying time may be such an extent that substantially all of the diluent contained in the applied pressure-sensitive adhesive is volatilized, and is preferably 10 minutes or more, more preferably 20 minutes or more, and still more preferably 30 minutes or more, from the viewpoint of keeping the amount of volatile components at 150°C below a certain level and facilitating the enhancement of the adhesion after heating at high temperatures, for example, in a reflow process. The drying time is preferably 30 hours or less, more preferably 6 hours or less, and still more preferably 3 hours or less, from the viewpoint of keeping the amount of volatile components at 150°C above a certain level and facilitating the enhancement of the initial adhesion.

Further, the above-described drying is preferably performed under normal pressure, but may be reduced-pressure drying performed under reduced pressure or vacuum drying. In reduced-pressure or vacuum drying, the drying temperature may be appropriately lowered, or the drying time may be appropriately shortened.

The production method described above is merely an example, and the heat conductive sheet may need not be produced according to the production method. For example, it may be produced according to another method that omits step 3 described above. In that case, the heat conductive sheet may contain a pressure-sensitive adhesive in the heat conductive layer without a pressure-sensitive adhesive layer. The heat conductive layer with the pressure-sensitive adhesive contained in the heat conductive layer may be formed into a heat conductive sheet or placed on the surface of the heat conductive sheet to make at least one surface of the heat conductive sheet pressure-sensitive adhesive. In this case, the pressure-sensitive adhesive may be blended in the mixed composition in step 1.

Since the pressure-sensitive adhesive to be contained in the heat conductive layer is as described above, a detailed description thereof is omitted. When the pressure-sensitive adhesive is contained in the heat conductive layer to omit step 3 described above, the pressure-sensitive adhesive in step 1 may be appropriately mixed in any order with the curable polymer composition, heat conductive filler, volatile substance added, when necessary, and another component added, when necessary.

When a pressure-sensitive adhesive is blended into the mixed composition in step 1, the pressure-sensitive adhesive may be diluted with a diluent and blended into the mixed composition as a pressure-sensitive adhesive diluted solution or may be blended into the mixed composition without being diluted with a diluent. Since the diluent is also as described above, a detailed description thereof is omitted. When the pressure-sensitive adhesive diluted solution is blended into the mixed composition, the diluent may volatilize during heating in step 2 described above.

### [Use of Heat Conductive Sheet]

The heat conductive sheet, which is interposed between a heating element and a heat sink, transfers heat generated by the heating element to the heat-dissipating element through thermal conduction to dissipate the heat from the heat-dissipating element. The heat conductive sheet is used in electronics applications, semiconductor applications, and the like, preferably semi-conductor applications. Although the heat conductive sheet may be used in any application when the sheet is used in semiconductor applications, it is preferably to be used in an application where it is applied directly to a semiconductor chip such as a silicon die, referred to as TIM1, for example, between a semiconductor chip and a heat spreader.

Of course, it may also be used in applications that are not directly applied to a semiconductor chip, referred to as TIM2. In such a case, the heat conductive sheet may be used, for example, between a heat spreader and a cooling unit such as a heatsink or a heat pipe.

In addition, the heat conductive sheet may be used between various electronic components serving as heating elements and heat sinks such as a heat spreader, a heatsink, a heat pipe, a heat pump, and a metal housing of an electronic device.

The heat conductive sheet is also preferably used in a semiconductor testing process for inspecting a semiconductor element such as a semiconductor package. In particular, the heat conductive sheet is preferably used between a test head and a semiconductor package in the semiconductor testing process.

The heat conductive sheet may be used by being placed between two members (adherends) such as a heat-dissipating element and a heating element and may be used in a state of being adhered to each member (adherend) and being compressed.

The heat conductive sheet may be laminated on the adherend at normal temperature, or may be mounted on the adherend by being heated to an appropriate temperature and then laminated on the adherend, as described later.

The heat conductive sheet may be used as a laminated body including at least one surface to which a metal foil such as an aluminum foil is bonded. The laminate body may be formed by bonding a metal foil to the heat conductive sheet of the present invention having pressure-sensitive adhesive properties on the surface thereof, which is obtained by applying a pressure-sensitive adhesive to one surface of the heat conductive sheet to form a pressure-sensitive adhesive layer. Alternatively, the metal foil may be laminated while forming a heat conductive sheet of the present invention by applying a pressure-sensitive adhesive to the surface of the metal foil and bonding the metal foil to the heat conductive sheet to which the pressure-sensitive adhesive is not applied. Furthermore, when the metal foil is laminated on only one side of the heat conductive sheet, the other side of the heat conductive sheet may or may not be coated with the pressure-sensitive adhesive. From the viewpoint of enhancing the adhesion of both surfaces of the heat conductive sheet to the adherend, however, it is preferable to apply the pressure-sensitive adhesive to the other side of the heat conductive sheet to form the pressure-sensitive adhesive layer.

As illustrated in Fig. 1, an adhesive 11 for fixing a LID 10 used in a semiconductor package or the like may be applied in the vicinity of a heat conductive sheet 12 upon installing. In such a case, when the heat conductive sheet 12 is installed on an adherend 13 such as an IC chip, an arrangement 1 including the LID 10, the adhesive 11, the heat conductive sheet 12, and the adherend 13 may be heated. Through the heating, a pressure-sensitive adhesive in the adhesive 11 can be cured to fix the LID 10 to a substrate 14 on which the IC chip or the like is installed via the adhesive 11 before the reflow process. Note that the member for fixing the LID 10 to the substrate is not limited to the adhesive 11, and may be a seal material or the like. For example, in the case of using a seal material, the seal material is preferably bonded to the substrate 14 to fix the LID 10 to the substrate via the seal material while the pressure-sensitive adhesive of the seal material is cured by the heating.

As a result, it is possible to prevent the LID 10 or the like from being displaced during the reflow process. During heating, the heat conductive sheet 12 may be appropriately pressurized and laminated on the adherend 13 by thermocompression bonding. The heat conductive sheet 12 may also be adhered to the adherend 13 via at least one surface of the heat conductive layer having pressure-sensitive properties.

The heating temperature during mounting may be lower than the temperature during heating at a high temperature described later, for example, about 100 to 200°C, preferably about 120 to 170°C. The heat conductive sheet has a small amount of volatile components at 150°C, thereby preventing the adhesion of the heat conductive sheet to the adherend from decreasing due to heating during installing.

The heat conductive sheet is preferably used in an application where it is heated to a high temperature of, for example, 200°C or more and 300°C or less, preferably 220°C or more and 270°C or less, while being adhered to the adherend via at least one surface of the heat conductive layer having pressure-sensitive adhesive properties. Even when the heat conductive sheet is heated to high temperatures in a state of being adhered to the adherend, the adhesive force to the adherend is prevented from decreasing as described above, thus preventing the sheet from peeling or the like from the adherend even when heated to high temperatures.

In semiconductor applications, the heat conductive sheet may be mounted to be tightly adhered to an adherend such as a substrate or silicon wafer. The heat conductive sheet is preferably subjected to the reflow process in a state of tightly adhering to the adherend, wherein it may be heated in the above-described high temperature range in the reflow process. Note that the heat conductive sheet may be heated in the reflow process in a state of adhering to, for example, a semiconductor chip, a heat splitter as an adherend or both.

### Examples

Hereinafter, the present invention is described in more detail with reference to Examples, but these examples do not limit the present invention in any way.

Measurement methods and evaluation methods in the present Examples are as follows.

### [Sheet Thickness]

The thickness (initial thickness) of the heat conductive sheet was measured with a thickness gauge.

### [Tack Value]

A tack tester TA-500 manufactured by UBM was used, and the heat conductive sheet was fixed on a stage with double-sided tape. Then, the maximum load measured under the following measurement conditions was defined as a tack value (N). As the double-sided tape, a double-sided tape "NICETACK NW-K15" manufactured by NICHIBAN Co., Ltd. was used.
(Measurement Conditions)
Probe diameter: 5 mmφ
Press load: 20N
Holding time: 10 sec
Pull-up rate: 0.1 mm/sec
Measurement environment: 23°C, 50% RH

### [Amount of Volatile Components at 150°C]

To specify a residual solvent in the sample, thermal desorption GC-MS was performed according to the following conditions.

### <Thermal Desorption GC-MS Measurement Conditions>

Thermal desorption device: TurboMatrix 350 (PerkinElmer)
Sample volume: 5 mg, precisely weighed
Heating: 150°C for 10 minutes (20 mL/min)
Secondary desorption: 350°C
Split: inlet at 25 mL/min, outlet at 25 mL/min, and injection volume at 2.5%
GC-MS System: Agilent7890B & JMS-Q1500GC (manufactured by JEOL Ltd.)
Column: EQUITY-1 (non-polar), 0.32 mm × 60 m × 0.25 µm
GC temperature rise: 40°C (4 min) → 300°C (10 min)(temperature rise at a rate of 10°C /min)
He flow rate: 1.5 mL/min (split ratio of 1:30)
Ionization potential: 70 eV
MS measurement range: 29 to 600 amu (scan at 500 ms)
MS temperature: 230°C for ion source and 250°C for interface

For quantitative determination, the peak area of toluene was measured in a Tenax tube adsorbed with 2 µL of a methanol solution having a toluene concentration of 100 ppm under the same conditions as the sample.

### [Amount of Volatile Components at 260°C]

To specify a residual solvent in the sample, thermal desorption GC-MS was performed according to the following conditions. The measurement of the amount of volatile components at 260°C was made using samples taken after the measurement of the amount of volatile components at 150°C.

### <Thermal Desorption GC-MS Measurement Conditions>

Thermal desorption device: TurboMatrix 350 (PerkinElmer)
Sample volume: 5 mg, precisely weighed
Heating: 260°C, 5 min (20 mL/min)
Secondary desorption: 350°C
Split: inlet at 25 mL/min, outlet at 25 mL/min, and injection volume at 2.5%
GC-MS System: Agilent7890B & JMS-Q1500GC (manufactured by JEOL Ltd.)
Column: EQUITY-1 (non-polar), 0.32 mm × 60 m × 0.25 µm
GC temperature rise: 40°C (4 min) → 300°C (10 min)(temperature rise at a rate of 10°C/min)
He flow rate: 1.5 mL/min (split ratio of 1:30)
Ionization potential: 70 eV
MS measurement range: 29 to 600 amu (scan at 500 ms)
MS temperature: 230°C for ion source and 250°C for interface

For quantitative determination, the peak area of toluene was measured in a Tenax tube adsorbed with 2 µL of a methanol solution having a toluene concentration of 100 ppm under the same conditions as the sample.

### [SAT Coverage]

SAT coverage by thermocompression bonding was obtained based on the following procedures 1. to 3.
1. A copper plate having a 30 mm square and a silicon wafer were prepared one by one, the heat conductive sheet obtained in each of Examples and Comparative Examples was sandwiched between the copper plate and the silicon wafer, a weight was placed on the copper plate, and the copper plate and the silicon wafer were heated at 150°C for 10 minutes, and pressure-bonded in a state where the pressure of the 30 psi was applied, thereby obtaining a sample for SAT.
2. Using the sample obtained in 1. above, scanning acoustic tomography (SAT) was conducted to obtain an observation image of the heat conductive sheet. SAT was performed using a high-precision ultrasonography device ("C-SAM D9500" manufactured by Nippon BARNES Company Ltd.).
3. The image obtained in 2. above was binarized using the image processing software ImageJ under the condition of a luminance value of 251, and the colored portion occupied in the image was regarded as an adhered portion. Then, the portion of the adhered portion in the total area was obtained as the SAT coverage by thermocompression bonding. Note that in the scanning acoustic tomography, the SAT coverage was calculated at the interface between the copper plate and the heat conductive sheet.

The SAT coverage after heating at high temperature was obtained by further heating the sample obtained in 1. above at 260°C for 3 minutes and then determining the SAT coverage by the methods 2. and 3. The heating at 260°C for 3 minutes was performed in a reflow oven ("UNI-5016F" manufactured by ANTOM Co., Ltd) in the same manner as in the reflow process.

The following components were used as raw materials of the heat conductive sheet.

### (Base Resin and Curing Agent)

Curable silicone: addition-reaction type organopolysiloxane composed of an alkenyl group-containing organopolysiloxane as a base resin and a hydrogenorganopolysiloxane as a curing agent (including a catalytic amount of a platinum catalyst, however)

### (Volatile Substance)

n-Decyltrimethoxysilane

### (Heat Conductive Filler)

Aluminum oxide 1: polyhedral shape, average particle diameter (D50) = 0.5 µm, aspect ratio of 1.0
Aluminum oxide 2: polyhedral shape, average particle diameter (D50) = 3.0 µm, aspect ratio of 1.0
Aluminum: spherical shape, average particle diameter (D50) = 3 µm, aspect ratio of 1.0 to 1.5
Graphitized carbon fiber: average fiber length (arithmetic mean) of 85 µm, diameter of 10 µm, aspect ratio of 8.5, thermal conductivity of 900 W/m·K
Flake graphite powder: average particle diameter (D50) = 15 µm, aspect ratio of 10, thermal conductivity of 550 W/m·K

### (Polymeric Dispersant)

Pyrene dispersant: organopolysiloxane having pyrene shown in the synthetic method described later, number-average molecular weight of 17,000

### (Synthesis of Pyrene Dispersant)

First, 98.6 g of an organosiloxane compound having a 1,3-diol group (n = 210), 1.4 g of 1-pyrenecarboxaldehyde, 50 g of toluene as a solvent, and 0.6 g of a catalyst ("Amberlyst 15 dry" manufactured by Organo Corporation) were reacted at 100°C for 24 hours in a nitrogen atmosphere. After the reaction, the catalyst was removed by filtration through a 5.0 µm PTFE filter, and the filtrate was concentrated with a rotary evaporator and a vacuum dryer to obtain a pyrene dispersant 1. The reaction formula is given below. Note that the progress of the following reaction was confirmed by ¹H NMR measurement. The measurement was carried out with "ECX-400" manufactured by JEOL as an NMR measuring device using deuterated chloroform as a solvent under the following conditions: sample concentration of 1% by weight, 25°C, measurement frequency of 400 MHz, and number of accumulations of 8 times.

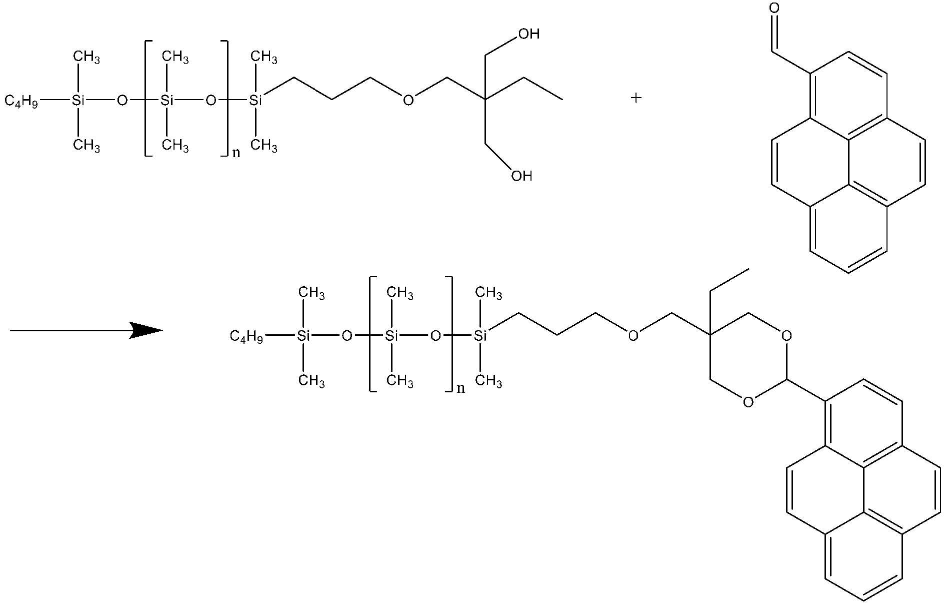

### (Pressure-Sensitive Adhesive)

A pressure-sensitive adhesive in which the pressure-sensitive adhesive base resin is an acrylic-based polymer containing a 2-ethylhexyl acrylate-derived structural unit as the main component and having a hydroxy group, a carboxyl group, and a vinyl group in the side chain. * Note that 100 parts by mass of a diluted solution of the pressure-sensitive adhesive diluted with ethyl acetate to a solid content concentration of 33% by mass was further diluted with 150 parts by mass of propylene glycol monomethyl ether acetate (solvent) to prepare a coating liquid with a solid content concentration of 13.2% by mass, which was used in each of Examples and Comparative Examples.

### [Example 1]

According to the formulation shown in Table 1, the respective components were mixed using a planetary mixer at 25°C for 50 minutes to obtain a mixed composition. Subsequently, the mixed composition was injected into a mold set to have a thickness sufficiently larger than that of the heat conductive sheet, the magnetic field of 8T was applied in the thickness direction to orient the carbon fiber and flake graphite in the thickness direction, and then the curable silicone was primarily cured by heating at 80°C for 8 hours to obtain a block-shaped oriented formed product.

Next, the block-shaped oriented formed product was sliced into a sheet having a thickness of 100 µm using a shear blade, thereby obtaining a sheet-like formed product in which the carbon fiber was exposed. Thereafter, the sheet-like formed product was heated at 150°C for 6 hours to perform secondary curing.

Subsequently, the sheet-like formed product was reciprocally polished 75 times with coarse sandpaper A (grain size: #800) having an average grain diameter (D50) of abrasive grains of 20 µm, and then was further reciprocally polished 10 times with coarse sandpaper B (grain size: #4000) having an average grain diameter (D50) of abrasive grains of 3 µm.

**[Table 1]**

| Components | Formulation |
|---|---|
| Curable silicone | 100 |
| n-Decyltrimethoxysilane | 15 |
| Aluminum oxide 1 | 30 |
| Aluminum | 243 |
| Graphitized carbon fiber | 160 |
| Flake graphite powder | 20 |
| Sheet hardness | 59 |

| | |
|---|---|
| *Values of the respective components in Table 1 are expressed as parts by mass. *Sheet hardness refers to the type E hardness measured for a cured product obtained from the formulation in each of Examples and Comparative Examples. | |

The pressure-sensitive adhesive coating liquid was sprayed onto both surfaces of the obtained sheet-like formed product by adjusting the discharge amount so that the basis weight after drying was the amount listed in Table 5, and then dried under the drying conditions listed in Table 5, thereby obtaining a heat conductive sheet having an acrylic pressure-sensitive adhesive layer provided on both surfaces of the heat conductive layer (sheet-like formed product).

### [Examples 2 and 4]

A heat conductive sheet having an acrylic pressure-sensitive adhesive layer provided on both surfaces of the heat conductive layer was obtained in the same procedure as in Example 1, except that the base weight or drying conditions was changed as described in Table 5.

### [Example 3]

A heat conductive sheet having an acrylic pressure-sensitive adhesive layer provided on both surfaces of the heat conductive layer was obtained in the same procedure as in Example 1, except that the material of the block-shaped oriented formed product was changed according to the formulation listed in Table 2.

**[Table 2]**

| Components | Formulation |
|---|---|
| Curable silicone | 100 |
| n-Decyltrimethoxysilane | 3 |
| Pyrene dispersant | 10 |
| Aluminum oxide 1 | 30 |
| Aluminum oxide 2 | 300 |
| Graphitized carbon fiber | 160 |
| Flake graphite powder | 20 |
| Sheet hardness | 40 |

| | |
|---|---|
| *Values of the respective components in Table 2 are expressed as parts by mass. *Sheet hardness refers to the type E hardness measured for a cured product obtained from the formulation in Example 3. | |

### [Example 5]

A heat conductive sheet having an acrylic pressure-sensitive adhesive layer provided on both surfaces of the heat conductive layer was obtained in the same procedure as in Example 1, except that the block-shaped oriented formed product was sliced into a sheet having a thickness of 200 µm.

### [Example 6]

A heat conductive sheet having an acrylic pressure-sensitive adhesive layer provided on one surface of the heat conductive layer was obtained in the same procedure as in Example 1, except that the material of the block-shaped oriented formed product was changed according to the formulation listed in Table 3, the drying conditions were changed as described in Table 6, and a pressure-sensitive adhesive coating liquid was sprayed onto only one side of the resulting sheet-like formed product.

**[Table 3]**

| Components | Formulation |
|---|---|
| Curable silicone | 100 |
| n-Decyltrimethoxysilane | 3 |
| Pyrene dispersant | 10 |
| Aluminum oxide 1 | 30 |
| Aluminum oxide 2 | 300 |
| Graphitized carbon fiber | 160 |
| Flake graphite powder | 20 |
| Sheet hardness | 60 |

| | |
|---|---|
| *Values of the respective components in Table 3 are expressed as parts by mass. *Sheet hardness refers to the type E hardness measured for a cured product obtained from the formulation in Example 6. | |

### [Example 7]

A heat conductive sheet having an acrylic pressure-sensitive adhesive layer provided on one surface of the heat conductive layer was obtained in the same procedure as in Example 6, except that the block-shaped oriented formed product was sliced into a sheet having a thickness of 200 µm.

### [Example 8]

A heat conductive sheet having an acrylic pressure-sensitive adhesive layer provided on one surface of the heat conductive layer was obtained in the same procedure as in Example 6, except that the block-shaped oriented formed product was sliced into a sheet having a thickness of 200 µm and, the base weight was changed as listed in Table 6.

### [Example 9]

A heat conductive sheet having an acrylic pressure-sensitive adhesive layer provided on one surface of the heat conductive layer was obtained in the same procedure as in Example 6, except that the block-shaped oriented formed product was sliced into a sheet having a thickness of 400 µm.

### [Example 10]

A heat conductive sheet having pressure-sensitive adhesive properties on both surfaces of the heat conductive layer was obtained in the same procedure as in Example 1, except that the material of the block-shaped oriented formed product was changed according to the formulation listed in Table 4, the pressure-sensitive adhesive was contained in the heat conductive layer instead of providing the pressure-sensitive layer, and spray coating was not performed. Note that the pressure-sensitive adhesive used in Example 10 was the same as those used in the other Examples and Comparative Examples, except that the pressure-sensitive adhesive was not diluted with various diluents.

**[Table 4]**

| Components | Formulation |
|---|---|
| Curable silicone | 100 |
| n-Decyltrimethoxysilane | 5 |
| Pyrene dispersant | 10 |
| Acrylic pressure-sensitive adhesive | 10 |
| Aluminum oxide 1 | 30 |
| Aluminum oxide 2 | 300 |
| Graphitized carbon fiber | 160 |
| Flake graphite powder | 20 |
| Sheet hardness | 40 |

| | |
|---|---|
| *Values of the respective components in Table 4 are expressed as parts by mass. *Sheet hardness refers to the type E hardness measured for the heat conductive sheet obtained in Example 10. | |

### [Comparative Example 1]

A heat conductive sheet having an acrylic pressure-sensitive adhesive layer provided on both surfaces of the heat conductive layer was obtained in the same procedure as in Example 1, except that the drying conditions and basis weight were changed as described in Table 7.

### [Comparative Example 2]

A heat conductive sheet having an acrylic pressure-sensitive adhesive layer provided on both surfaces of the heat conductive layer was obtained in the same procedure as in Example 1, except that the drying conditions were changed as described in Table 7.

### [Comparative Example 3]

A heat conductive sheet having no acrylic pressure-sensitive adhesive layer provided on both surfaces of the heat conductive layer was obtained in the same procedure as in Example 1, except that the pressure-sensitive adhesive coating liquid was not applied to both surfaces of the sheet-like formed product.

**[Table 5]**

| | Example 1 | Example 2 | Example 3 | Example 4 | Example 5 |
|---|---|---|---|---|---|
| Sheet type | Sheet 1 | Sheet 1 | Sheet 2 | Sheet 1 | Sheet 1 |
| Sheet thickness | 100 µm | 100 µm | 100 µm | 100 µm | 200 µm |
| Coating surface | Both sides | Both sides | Both sides | Both sides | Both sides |
| Basis weight (mg/cm²) | 0.34 | 0.70 | 0.34 | 0.34 | 0.34 |
| Drying condition | 100°C 60 min | 100°C 60 min | 100°C 60 min | Vacuum drying/35°C 30 min | 100°C 60 min |
| Tack value (N) | 5.14 | 6.16 | 5.37 | 4.04 | 4.81 |
| Amount of volatile component at 150°C | 15 ppm by mass | 49 ppm by mass | 30 ppm by mass | 24 ppm by mass | 2 ppm by mass |
| SAT coverage by thermocompression bonding | 74% | 84% | 67% | 70% | 73% |
| Amount of volatile component at 260°C | 805 ppm by mass | 2268 ppm by mass | 385 ppm by mass | 390 ppm by mass | 551 ppm by mass |
| SAT coverage after heating at high temperature | 70% | 80% | 62% | 69% | 69% |

**[Table 6]**

| | Example 6 | Example 7 | Example 8 | Example 9 | Example 10 |
|---|---|---|---|---|---|
| Sheet type | Sheet 3 | Sheet 3 | Sheet 3 | Sheet 3 | Sheet 4 |
| Sheet thickness | 100µm | 200µm | 200µm | 400µm | 100µm |
| Coating surface | One side | One side | One side | One side | - |
| Basis weight (mg/cm²) | 0.34 | 0.34 | 0.68 | 0.34 | - |
| Drying condition | Vacuum drying/35°C 30 min | Vacuum drying /35°C 30 min | Vacuum drying /35°C 30 min | Vacuum drying /35°C 30 min | - |
| Tack value (N) | 2.5 | 1.5 | 3.5 | 1.2 | 4.5 |
| Amount of volatile component at 150°C | 20 ppm by mass | 13 ppm by mass | 20 ppm by mass | 14 ppm by mass | 49 ppm by mass |
| SAT coverage by thermocompression bonding | 67% | 61% | 69% | 60% | 72% |
| Amount of volatile component at 260°C | 90 ppm by mass | 55 ppm by mass | 115 ppm by mass | 37 ppm by mass | 120% by mass |
| SAT coverage after heating at high temperature | 65% | 61% | 67% | 60% | 68% |

**[Table 7]**

| | Comparative Example 1 | Comparative Example 2 | Comparative Example 3 |
|---|---|---|---|
| Sheet type | Sheet 1 | Sheet 1 | Sheet 1 |
| Sheet thickness | 100µm | 100µm | 100µm |
| Coating surface | Both sides | Both sides | - |
| Basis weight (mg/cm²) | 0.70 | 0.34 | - |
| Drying condition | 50°C 5 min | 100°C 180 min | - |
| Tack value (N) | 7.66 | 3.21 | 1.92 |
| Amount of volatile component at 150°C | 136 ppm by mass | 0 ppm by mass | 0 ppm by mass |
| SAT coverage by thermocompression bonding | 71% | 57% | 58% |
| Amount of volatile component at 260°C | 2823 ppm by mass | 450 ppm by mass | 1059 ppm by mass |
| SAT coverage after heating at high temperature | 57% | 52% | 57% |

| | | | |
|---|---|---|---|
| *In Tables 5 to 7, "sheet type" refers to the type of heat conductive layer in different formulations. Specifically, "sheet 1" refers to the heat conductive layer obtained from the formulation listed in Table 1, "sheet 2" refers to the heat conductive layer obtained from the formulation listed in Table 2, "sheet 3" refers to the heat conductive layer obtained from the formulation listed in Table 3, and "sheet 4" refers to the heat conductive layer obtained from the formulation listed in Table 4. | | | |

As it is apparent from the above results, the SAT coverage, which is an index of adhesion, of the heat conductive sheet produced in each Example increased before and after the reflow process involving heating at a high temperature because the amount of volatile components at 150°C was within a certain range.

In contrast, the SAT coverage of the heat conductive sheet produced in Comparative Example 1 significantly decreased after the reflow process because the amount of volatile components at 150°C was excessive. Since the amount of volatile components in the heat conductive sheet produced in Comparative Example 2 was too small at 150°C, the SAT coverage was low not only after the reflow process but also before the reflow process. In other words, excellent initial adhesion was not obtained. Furthermore, as in Comparative Example 2, excellent initial adhesion was not obtained with the heat conductive sheet produced in Comparative Example 3, in which the coating liquid of the pressure-sensitive adhesive was not applied.

### Reference Signs List

1 arrangement
10 LID
11 adhesive
12 heat conductive sheet
13 adherend
14 substrate

## Claims

1. A heat conductive sheet comprising a heat conductive layer comprising a polymer matrix and a heat conductive filler, at least one surface of the heat conductive sheet having pressure-sensitive adhesive properties,
in the heat conductive sheet, an amount of volatile components measured by thermal desorption GC-MS at 150°C being 2 ppm by mass or more and 80 ppm by mass or less.

2. The heat conductive sheet according to claim 1, wherein the polymer matrix is organopolysiloxane.

3. The heat conductive sheet according to claim 1 or 2, comprising a pressure-sensitive adhesive layer on at least one surface of the heat conductive layer.

4. The heat conductive sheet according to claim 3, wherein the pressure-sensitive adhesive layer is formed by spray coating.

5. The heat conductive sheet according to claim 3, wherein the pressure-sensitive adhesive layer is an acrylic pressure-sensitive adhesive layer.

6. The heat conductive sheet according to claim 5, wherein the acrylic pressure-sensitive adhesive layer comprises a reactive double bond.

7. The heat conductive sheet according to claim 1 or 2, wherein the pressure-sensitive adhesive properties are lost due to heating at 260°C for 3 minutes.

8. The heat conductive sheet according to claim 1 or 2, wherein, in the heat conductive sheet, an amount of volatile components measured by thermal desorption GC-MS at 260°C is 2500 ppm by mass or less.

9. The heat conductive sheet according to claim 1 or 2, wherein a pressure-sensitive adhesive force of the at least one surface measured with a tack test is 2 N or more.

10. A heat conductive sheet comprising a heat conductive layer comprising a polymer matrix and a heat conductive filler, at least one surface of the heat conductive layer having pressure-sensitive adhesive properties,
in the heat conductive sheet, an amount of volatile components measured by thermal desorption GC-MS at 150°C being 2 ppm by mass or more and 80 ppm by mass or less.
